(19) **Europäisches Patentamt / European Patent Office / Office européen des brevets**

(11) **EP 4 646 083 A1**

(12) **EUROPEAN PATENT APPLICATION**
published in accordance with Art. 153(4) EPC

(43) Date of publication:
**05.11.2025 Bulletin 2025/45**

(21) Application number: **23912693.1**

(22) Date of filing: **14.12.2023**

(51) International Patent Classification (IPC):
*H10K 59/38* (2023.01)          *H10K 59/123* (2023.01)
*H10K 59/80* (2023.01)          *H10K 59/35* (2023.01)
*H10K 50/15* (2023.01)          *H10K 50/16* (2023.01)
*H10K 50/17* (2023.01)

(52) Cooperative Patent Classification (CPC):
**H10K 50/15; H10K 50/16; H10K 50/17;
H10K 59/123; H10K 59/35; H10K 59/38;
H10K 59/80**

(86) International application number:
**PCT/KR2023/020613**

(87) International publication number:
**WO 2024/144018 (04.07.2024 Gazette 2024/27)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **30.12.2022 KR 20220190847**

(71) Applicants:
• **Yas Co., Ltd.**
  **Paju-si, Gyeonggi-do 10857 (KR)**
• **Ahn, Byungchul**
  **Seoul 06574 (KR)**

(72) Inventor: **AHN, Byungchul**
  **Seoul 06574 (KR)**

(74) Representative: **Epping - Hermann - Fischer
Patentanwaltsgesellschaft mbH
Schloßschmidstraße 5
80639 München (DE)**

(54) **ORGANIC LIGHT-EMITTING DISPLAY DEVICE**

(57)     An organic light-emitting display device can include a substrate, an auxiliary electrode in each of a plurality of subpixels, a three-dimensional structure on the auxiliary electrode, an organic light-emitting element surrounding the three-dimensional structure, an encapsulation layer surrounding the organic light emitting device, and a resin layer on the encapsulation layer.

The organic light-emitting element can include an anode electrode surrounding an upper surface and a side surface of the three-dimensional structure and is connected to an auxiliary electrode through the side surface of the three-dimensional structure, an organic light-emitting layer on the anode electrode, and a cathode electrode on the organic light-emitting layer.

FIG. 1

EP 4 646 083 A1

**Description**

**BACKGROUND OF THE DISCLOSURE**

**Field**

The embodiment relates to an organic light-emitting display device.

**Discussion of the Related Art**

Recently, as we enter the full-fledged information age, interest in display devices that process and display large amounts of information has exploded. In particular, as users' demands for using portable information media increase, the display field has developed rapidly, and in response to this, various lightweight and thin flat panel display devices have been developed and are in the spotlight.

Among these flat display devices, a head-mounted display (HMD)-type display device is attracting attention. In particular, active development is underway for an organic light-emitting display (OLED) to be used as HMD-type display device. The HMD-type display device is worn in the form of a helmet or glasses to form a focus for the image in the user's eyes, thereby realizing virtual reality (VR) or augmented reality (AR).

The HMD-type display device can be equipped with small, high-resolution OLED. The small, high-resolution OLED comprises a plurality of organic light-emitting elements on a driving circuit formed using a wafer-based semiconductor process. Meanwhile, when the HMD-type display device is implemented as a glasses type, a brighter and clearer screen is required at a very small screen size. To achieve this, image quality needs to be improved by maximizing the amount of light from the organic light-emitting element and its light extraction efficiency and blocking light leakage between pixels or subpixels. The light extraction efficiency improvement technology that can be applied to ultra-high resolution is expected to be widely applied to the large-screen display industry such as mobile devices and IT devices.

**SUMMARY OF THE DISCLOSURE**

An object of the embodiment is to solve the foregoing and other problems.

Another object of the embodiment is to provide an organic light-emitting display device that can improve luminance by expanding the area of an organic light-emitting layer of the organic light-emitting element and secure clear image quality by preventing leakage current and light leakage between pixels or subpixels.

In order to achieve the above-described problem, according to one aspect of the embodiment, an organic light-emitting display device, comprising: a substrate comprising a plurality of pixels, each of the plurality of pixels comprising a plurality of subpixels; an auxiliary electrode in each of the plurality of subpixels; a three-dimensional structure on the auxiliary electrode; an organic light-emitting element surrounding the three-dimensional structure; an encapsulation layer surrounding the organic light-emitting element; and a resin layer on the encapsulation layer, wherein the organic light-emitting element comprises: an anode electrode surrounding an upper surface and a side surface of the three-dimensional structure and is connected to the auxiliary electrode through the side surface of the three-dimensional structure; an organic light-emitting layer on the anode electrode; and a cathode electrode on the organic light-emitting layer.

According to another aspect of the embodiment, an organic light-emitting display device, comprising: a substrate comprising a plurality of pixels, each of the plurality of pixels comprising a plurality of subpixels; a driving circuit in each of the plurality of subpixels; a protective layer disposed on the driving circuit and comprising two or more protective films; an auxiliary electrode disposed on the protective layer and connected to the driving circuit through a through hole in the protective layer; an anode separation structure provided along a perimeter of the auxiliary electrode; a three-dimensional structure on the auxiliary electrode; an organic light-emitting element surrounding the three-dimensional structure; an encapsulation layer surrounding the organic light-emitting element; and a resin layer on the encapsulation layer, wherein the organic light-emitting element comprises: an anode electrode surrounding an upper surface and a side surface of the three-dimensional structure and is connected to the auxiliary electrode through the side surface of the three-dimensional structure; an organic light-emitting layer on the anode electrode; and a cathode electrode on the organic light-emitting layer, and wherein the anode separation structure has an undercut structure in which the ends of each of the two or more protective films are positioned differently along a corner of the auxiliary electrode to disconnect the anode electrode.

According to another aspect of the embodiment, an organic light-emitting display device, comprising: a substrate comprising a plurality of pixels, each of the plurality of pixels comprising a plurality of subpixels; an auxiliary electrode in each of the plurality of subpixels; a three-dimensional structure on the auxiliary electrode; an organic light-emitting element surrounding the three-dimensional structure; an encapsulation layer surrounding the organic light-emitting element; a light guide layer on the encapsulation layer; and a resin layer on the encapsulation layer, wherein the organic light-emitting element comprises: an anode electrode surrounding a side surface of the three-dimensional structure and is connected to the auxiliary electrode through the side surface of the three-dimensional structure; an organic light-emitting layer on the anode electrode; and a cathode electrode on the organic light-emitting layer, and wherein the light guide layer is disposed on the side surface of the three-dimensional structure.

According to at least one of the embodiments, the light-emitting area can be dramatically increased by disposing the organic light-emitting element on the surfaces of the three-dimensional structure. In the case of the three-dimensional structure of a cube, organic light-emitting elements can be disposed on all surfaces of the cube. In this instance, when the organic light-emitting element is disposed on all surfaces of the cube compared to the organic light-emitting element being disposed on one side surface of the cube, the light-emitting area can be expanded by at least 5 times. Therefore, luminance as well as lifespan can be improved.

In addition, the first resin layer located on at least one side surface of the three-dimensional structure can prevent light leakage between pixels or subpixels, thereby ensuring clear image quality. At this time, when the color resin is used as the first resin layer, an organic light-emitting display device with improved color purity can be provided.

In addition, by providing an anode separation structure, light emission due to current leakage to adjacent pixels or subpixels is blocked, resulting in clearer image quality.

## BRIEF DESCRIPTION OF THE DRAWINGS

FIG. 1 is an exploded perspective view showing an organic light-emitting display device according to a first embodiment.

FIGS. 2A to 2I are perspective views showing various shapes of three-dimensional structures according to embodiments.

FIG. 3 is a plan view showing an example of a combination of two different types of three-dimensional structures according to an embodiment.

FIG. 4 is a cross-sectional view taken along line A-A' of the organic light-emitting display device according to the first embodiment.

FIG. 5 shows an optical path when an organic light-emitting element emits light in an organic light-emitting display device according to the first embodiment.

FIG. 6 is a flowchart explaining a manufacturing method of an organic light-emitting display device according to the first embodiment.

FIGS. 7A to 7N are cross-sectional views showing a method of manufacturing an organic light-emitting display device according to the first embodiment.

FIG. 8 is a flowchart explaining a method of manufacturing an organic light-emitting display device having an anode separation structure according to a second embodiment.

FIG. 9 is a cross-sectional view showing an example of an anode separation structure according to the second embodiment.

FIGS. 10A to 10G are cross-sectional views showing a method of manufacturing an organic light-emitting display device having an anode separation structure according to the second embodiment.

FIG. 11 is a table explaining the materials or material characteristics of the components that make up each of the first to eighth embodiments.

FIG. 12 is a cross-sectional view showing an organic light-emitting display device according to a third embodiment.

FIG. 13 is a cross-sectional view showing an organic light-emitting display device according to a fourth embodiment.

FIG. 14 is a cross-sectional view showing an organic light-emitting display device according to a fifth embodiment.

FIG. 15 shows an optical path when an organic light-emitting element emits light in an organic light-emitting display device according to the fifth embodiment.

FIG. 16 is a flowchart explaining a method of manufacturing an organic light-emitting display device according to the third to fifth embodiments.

FIG. 17 is a cross-sectional view showing an organic light-emitting display device according to the sixth embodiment.

FIG. 18 is a cross-sectional view showing an organic light-emitting display device according to the seventh embodiment.

FIG. 19 is a cross-sectional view showing an organic light-emitting display device according to the eighth embodiment.

FIG. 20 shows an optical path when an organic light-emitting element emits light in an organic light-emitting display device according to the seventh embodiment.

FIG. 21 is a flowchart explaining a manufacturing method of an organic light-emitting display device according to the sixth to eighth embodiments.

The sizes, shapes, dimensions, etc. of elements shown in the drawings can differ from actual ones. In addition, even if the same elements are shown in different sizes, shapes, dimensions, etc. between the drawings, this is only an example on the drawing, and the same elements have the same sizes, shapes, dimensions, etc. between the drawings.

## DETAILED DESCRIPTION OF EMBODIMENTS

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there can be directly on the other element or be other intermediate elements therebetween.

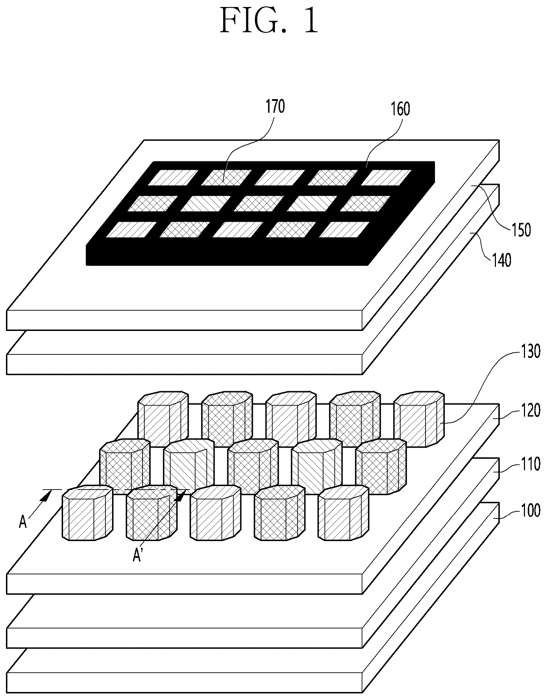

FIG. 1 is an exploded perspective view showing an organic light-emitting display device according to a first embodiment.

Referring to FIG. 1, the organic light-emitting display device according to the first embodiment has been described with a focus on forming an organic light-emitting element on a wafer substrate formed using a semiconductor process, but it should be noted that the organic light-emitting display device is not limited thereto. In other words, it can comprise an organic light-emitting display device manufactured on a glass substrate and made of a glass substrate, or an organic light-emitting display device manufactured on a glass substrate but the final product made of a plastic substrate. An organic light-emitting display device can comprise a plurality of pixels. Each of the plurality of pixels can comprise a first subpixel, a second subpixel, a third subpixel, etc. For example, the first subpixel can be a red subpixel, the second subpixel can be a green subpixel, and the third subpixel can be a blue subpixel. A protective layer 110, an auxiliary electrode 120, a plurality of three-dimensional structures 130, etc. can be included on the substrate 100 on which a driving circuit consisting of a transistor and a capacitor is formed. The protective layer 110 can sometimes be referred to as planarization layer 110, etc.

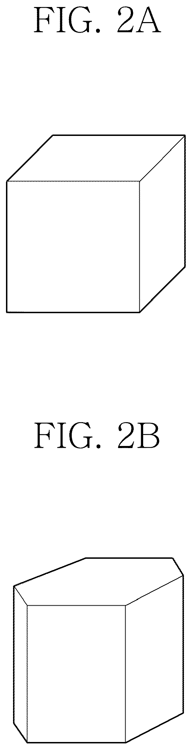

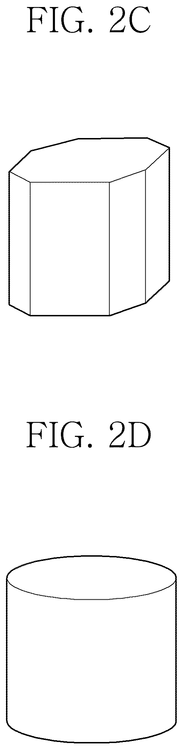

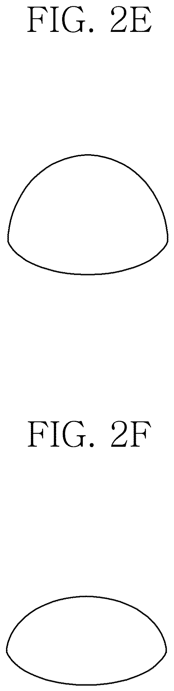

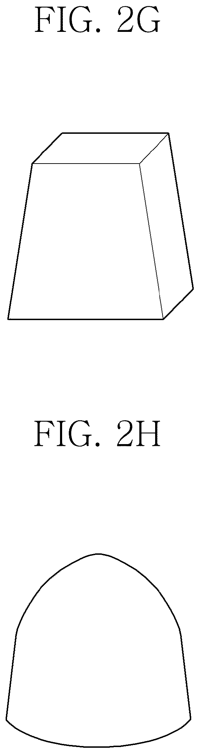

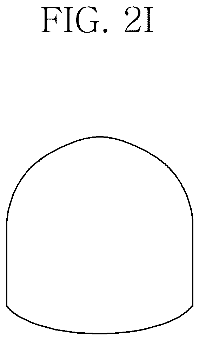

Each of the plurality of three-dimensional structures 130 can correspond to one subpixel, but is not limited thereto. The three-dimensional structure 130 can vary as shown in FIGS. 2A to 2I. That is, a tetrahedral shape (FIG. 2A), a hexahedral shape (FIG. 2B), an octahedral shape (FIG. 2C), a column shape such as a cylinder shape (FIG. 2D), a hemispheric or semi-elliptical shape (FIGS. 2E and 2F), a shape where the inner diameter decreases toward the upper side (FIGS. 2G to 2I) or a combination thereof. Additionally, it can be a combination of these three-dimensional structures up and down. For example. As shown in FIG. 2I, it can be formed by a combination of a cylinder shape (FIG. 2D) and a hemisphere shape (FIG. 2E).

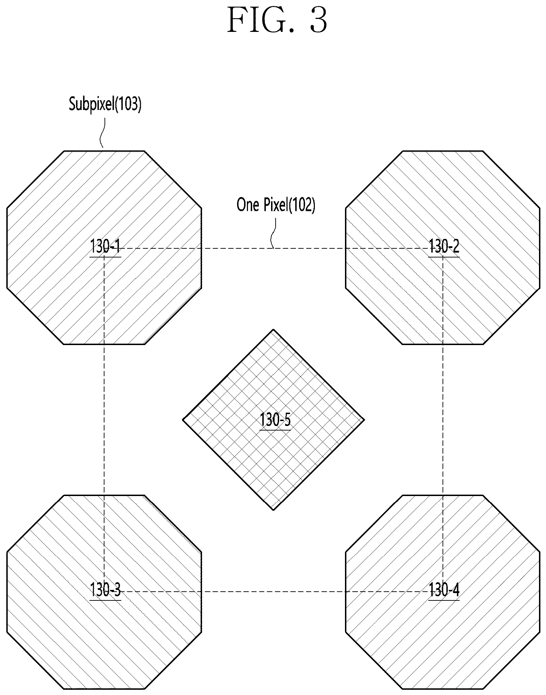

The different three-dimensional structures 130 can be combined so that subpixels are efficiently disposed within a unit pixel. For example, as shown in FIG. 3, at least one square pillar-shaped three-dimensional structure 130-5 can be disposed within four octagonal pillar-shaped three-dimensional structures 130-1 to 130-4 adjacent to each other. One pixel 102, that is, a unit pixel, can be defined by four octagonal pillar-shaped three-dimensional structures 130-1 to 130-4 and a square pillar-shaped three-dimensional structure 130-5. Each of the four octagonal pillar-shaped three-dimensional structures 130-1 to 130-4 and the square pillar-shaped three-dimensional structure 130-5 can each correspond to one subpixel 103. For example, the three-dimensional structure 130-1 can correspond to the red subpixel, the three-dimensional structures 130-2 and 130-4 can correspond to the green subpixel, and the three-dimensional structures 130-3 and 130-5 can correspond to the blue subpixel. For example, the three-dimensional structure 130-1 can correspond to a red subpixel, the three-dimensional structures 130-2 and 130-4 can correspond to green subpixels, the three-dimensional structure 130-3 can correspond to a blue subpixel, and the three-dimensional structure 1305 can correspond to a transparent subpixel that does not emit any color.

Referring again to FIG. 1, an organic light-emitting element 140 comprising an anode electrode, an organic light-emitting layer, a cathode electrode, etc. can be disposed on the three-dimensional structure 130. An encapsulation layer 150 can be disposed on the organic light-emitting element 140, and a first resin layer 160 and a second resin layer 170 can be disposed on the encapsulation layer 150. Other layers can be added on the second resin layer 170 for additional functions and purposes. For example, a planarization layer, an anti-reflection layer, etc. can be disposed on the second resin layer 170.

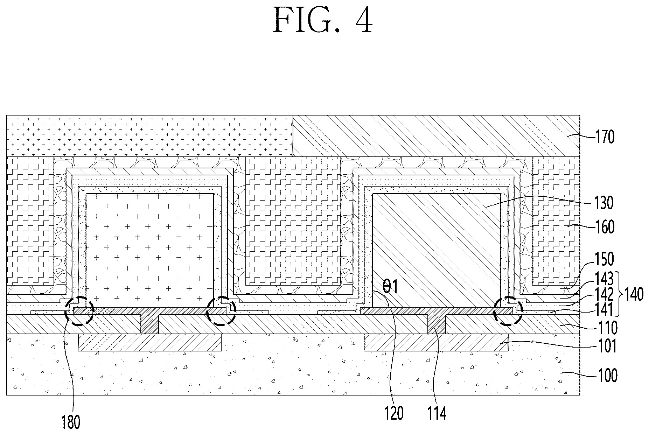

FIG. 4 is a cross-sectional view taken along line A-A' of the organic light-emitting display device according to the first embodiment.

Referring to FIGS. 1 and 4, a driving circuit 101 comprising a driving transistor, a capacitor, etc. can be formed on the substrate 100. The driving circuit 101 can be formed using a semiconductor process. The substrate 100 can comprise a silicon wafer, a plastic substrate, etc. A protective layer 110 can be disposed on the driving circuit.

The protective layer 110 can be a layer of an inorganic film or an organic film. The protective layer 110 can be a multi-layer of an inorganic film or a combination of a multi-layer of an inorganic film and an organic film. For example, the protective layer 110 can be formed of a silicon oxide film (SiOx), a silicon nitride film (SiNx), or a multilayer thereof. The protective layer 110 can be composed of a multi-structure of an organic film such as acryl resin, epoxy resin, phenolic resin, polyamide resin, or polyimide resin, and an inorganic film such as a silicon oxide film (SiOx), silicon nitride (SiNx), etc.

A drain electrode of the transistor can be connected to the auxiliary electrode 120 through a through hole 114 of the protective layer 110. The auxiliary electrode can be used as a pad to which power and signals are applied or used for inspection in areas other than the pixel comprising a plurality of subpixels.

The auxiliary electrode 120 can have the function of electrically connecting the drain electrode of the transistor to the anode electrode 141 of the organic light-emitting element 140 and the function of reflecting part of the light emitted from the organic light-emitting element 140. The auxiliary electrode 120 can be formed of a first metal film such as Ti or Mo to improve contact resistance characteristics, and can comprise a second metal film such as Ag, Ag alloy, or Al, which has good reflection performance, on the first metal film. A third metal film, such as ITO or IZO, can be formed on the second metal film for fairness and reliability. Therefore, the auxiliary electrode 120 can have, for example, a triple structure of ITO / (Ag or Ag alloy or Al) / (Ti or Mo) or a double structure of (Ag or Ag alloy or Al) / (Ti or Mo).

The three-dimensional structure 130 can be disposed on the auxiliary electrode 120. The three-dimensional structure 130 can be made of an inorganic film or an organic film. When the three-dimensional structure 130 is an inorganic layer, it can be formed of, for example, a silicon oxide layer (SiOx), a silicon nitride layer (SiNx), or a multilayer thereof. If the three-dimensional structure 130 is an organic film, it can be formed of, for example, an acrylic or polyimide-based resin, or it can be formed of a red, green, or blue color filter resin in which a pigment is dispersed in the resin. The three-dimensional structure 130 can have a shape where the inner diameter decreases toward the upper side, and its inclination $\theta 1$ can be 60 to 90 degrees. The inclination can be defined as an angle of the side surface with respect to the lower surface of the three-dimensional structure 130.

The auxiliary electrode 120 can be patterned using the pattern of the patterned three-dimensional structure 130 as a mask using the etch selectivity between the material of the three-dimensional structure 130 and the material of the auxiliary electrode 120. Accordingly, the auxiliary electrode 120 can be patterned to have the same shape and size as a pattern of a lower side of the three-dimensional structure 130. As the resolution increases, the alignment tolerance between films affects yield. Therefore, self-aligning the auxiliary electrode 120, which acts as a reflective film, and the three-dimensional structure 130, which plays an optically important role, can be effective in improving the performance of the organic light-emitting display device.

The position of the end of the auxiliary electrode 120 can be such that it protrudes or is recessed within 2 micrometers from the end of the corner of the lower surface of the three-dimensional structure 130. This can be implemented depending on the etching method (dry or wet, or a combination of the two methods) and whether an ashing process is added during the manufacturing process of patterning the auxiliary electrode. Since the auxiliary electrode 120 is etched using the pattern of the three-dimensional structure 130, the distance from the end of the corner of the three-dimensional structure 130 to the end of the corner of the auxiliary electrode 120 can protrude or be recessed at the same distance along the entire perimeter of the corner, but is not limited thereto.

The anode electrode 141 can be formed of a transparent conductive film TCO such as ITO or IZO that can transmit light. The transparent conductive film is formed using the sputtering method, so that it has good step coverage characteristics. Therefore, by using the sputtering method, a film can be formed not only on the protruding upper side of the auxiliary electrode 120 but also on the recessed side surface of the auxiliary electrode 120 to be electrically connected.

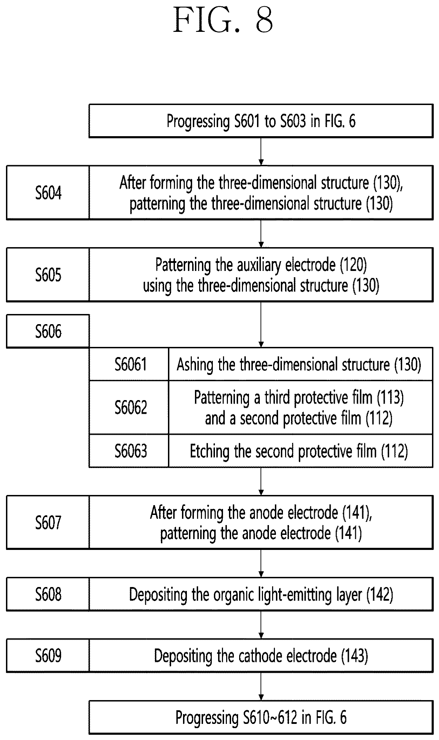

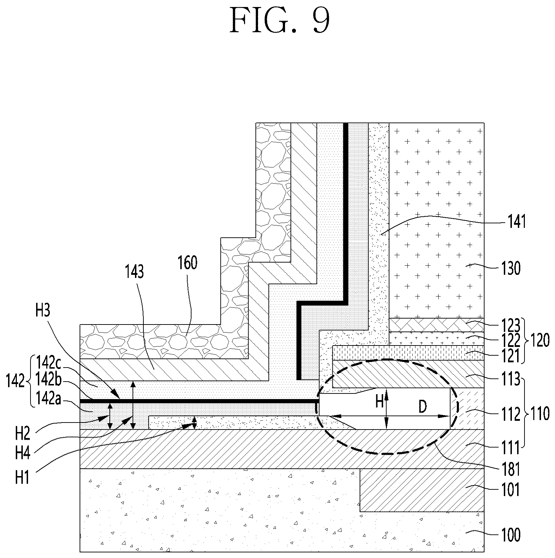

According to the applicant's internal technology, a pixel define layer (PDL) can be used after anode patterning for the purpose of defining subpixels and adjacent subpixels. In the PDL layer, a short circuit can occur as the current through the cathode electrode 143 and the organic light-emitting layer continues to be concentrated due to the current concentrated at a step difference of the corner of the anode electrode 141, causing a point defect. In order to solve this problem, or in a manufacturing method using a fine metal mask (FMM), the purpose is to mechanically protect subpixels and insert a structure to prevent leakage current between subpixels. In the embodiment, the transparent conductive film can be formed as thin as 50 nanometers or less. In the embodiment, the anode electrode 141 is connected to the auxiliary electrode 120 from the side surface thereof, so that a structure without a step difference can be achieved. When adding the anode separation structure 180, which will be explained later in the second embodiment (FIGS. 8 and 9), the problem of point defects due to short circuit between the anode and the cathode and leakage current between subpixels can be solved without configuring the PDL layer.

The organic light-emitting element 140 can be formed by depositing the organic light-emitting layer 142 and the cathode electrode 143 on the anode electrode 141. The organic light-emitting layer 142 can comprise a hole injection layer, a hole transport layer, a light-emitting layer, an electron transport layer, and an electron injection layer. In this instance, when voltage is applied to the anode electrode 141 and the cathode electrode 143, holes and electrons move to the light-emitting layer through the hole transport layer and the electron transport layer, respectively, and can combine with each other in the light-emitting layer to emit light.

The organic light-emitting layer 142 can comprise a white light-emitting layer that emits white light, but is not limited thereto. The organic light-emitting layer 142 can be formed in a tandem structure of two or more stacks. Each of the stacks can comprise a hole transport layer, at least one light-emitting layer, and an electron transport layer. Additionally, a charge generation layer can be formed between the stacks. The charge generation layer can comprise an n-type charge generation layer nCGL, a p-type charge generation layer pCGL, etc. between the lower stack (first stack) and the upper stack (second stack). A charge generation layer can be defined by pairing an n-type charge generation layer nCGL and a p-type charge generation layer pCGL. The n-type charge generation layer nCGL can be formed adjacent to the lower stack, and the p-type charge generation layer pCGL can be formed adjacent to the upper stack. The n-type charge generation layer injects electrons into the lower stack, and the p-type charge generation layer injects holes into the upper stack. The n-type charge generation layer can be made of an organic layer doped with an alkali metal such as Li, Yb, Na, K, Cs, etc., or an alkaline earth metal such as Mg, Sr, Ba, Ra, etc. The p-type charge generation layer can be formed by doping the hole transport layer with a dopant. For example, in the case of a tandem structure consisting of three stacks, the first organic light-emitting layer, the first charge generation layer, the second organic light-emitting layer, the second charge generation layer, and the third organic light-emitting layer can be disposed in that order on the anode electrode 141.

The cathode electrode 143 can be disposed on the organic light-emitting layer 142. The cathode electrode 143 can be a common layer commonly formed on each subpixel. The cathode electrode 143 can have a transparent conductive film made of a transparent conductive material TCO, a semi-transparent conductive film made of a translucent conductive material, or a double structure combining these. The transparent conductive materials TCO can ITO and IZO. For example, the cathode electrode 143 can be formed to a thickness of 20 nanometers or less using a translucent conductive material made of magnesium Mg, silver Ag, or an alloy of magnesium Mg and silver Ag.

In contrast, it can be used as a bottom emission method by forming a reflective material such as Al or Al alloy thicker than 80 nanometers as the cathode electrode 143. In this instance, the auxiliary electrode 120 can be composed of a single layer of a transparent conductive film such as ITO or IZO.

The encapsulation layer 150 can be disposed on the organic light-emitting element 140. The encapsulation layer 150 serves to prevent moisture or oxygen from penetrating into the organic light-emitting layer 142. To this end, the encapsulation layer 150 can comprise at least one inorganic layer and at least one organic layer. For example, the encapsulation layer 150 can have a triple structure comprising a first inorganic layer, a resin layer, and a second inorganic layer.

At least one or more resin layer 160 and 170 is formed on the encapsulation layer 150. As shown in FIGS. 1 and 4, the resin layer can comprise a first resin layer 160 made of black resin and a second resin layer 170 made of color filter resin, but is not limited thereto. One of the three-dimensional resin structure 130 and the second resin layer 170 can be used as a color resin, or both can be used as a color resin. Depending on the conditions of color purity, brightness, and power consumption required by the customer, which of the three-dimensional structure 130 and the second resin layer 170 will be used as a color resin can be selected. The color resin can also be called color filter resin.

For example, the three-dimensional structure 130 and the second resin layer 170 can be used as a color resin, the anode electrode 141 170 can be used as a transparent conductive film, and the cathode electrode 143 can be made of Ag:Mg alloy, but is not limited thereto.

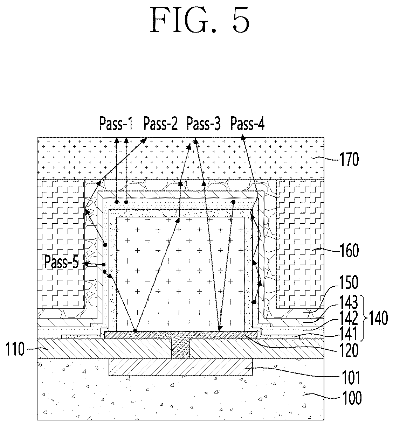

FIG. 5 shows the optical path when the organic light-emitting element emits light in the organic light-emitting display device according to the first embodiment.

Referring to FIG. 5, light emitted from the organic light-emitting element 140 disposed on the side surface and the upper surface of the three-dimensional structure 130 can be emitted inside and outside of the three-dimensional structure 130. Light incident into the three-dimensional structure 130 can be reflected by the auxiliary electrode 120 located below the three-dimensional structure 130 and the side surface of the three-dimensional structure 130 and be emitted toward an upper direction. Some of the light incident on the inside of the three-dimensional structure 130 can proceed upward through the perimeter of the three-dimensional structure 130. Light emitted to the outside of the three-dimensional structure 130 can be totally reflected multiple times at the interfaces of the cathode electrode 143, the encapsulation layer 150, and the anode electrode 141 and proceed toward an upper direction (Pass-1 to Pass4). Accordingly, light extraction efficiency can be increased and luminance can be improved.

Meanwhile, the first resin layer 160 used as a color resin can be disposed on the side surface of the three-dimensional structure 130 or between subpixels. In this instance, the first resin layer 160 can absorb light traveling on the side surface of the three-dimensional structure 130, that is, side light (Pass-5), thereby preventing light leakage between subpixels and improving color purity. However, the first resin layer 160 can absorb the side surface light (Pass-5), thereby reducing light extraction efficiency.

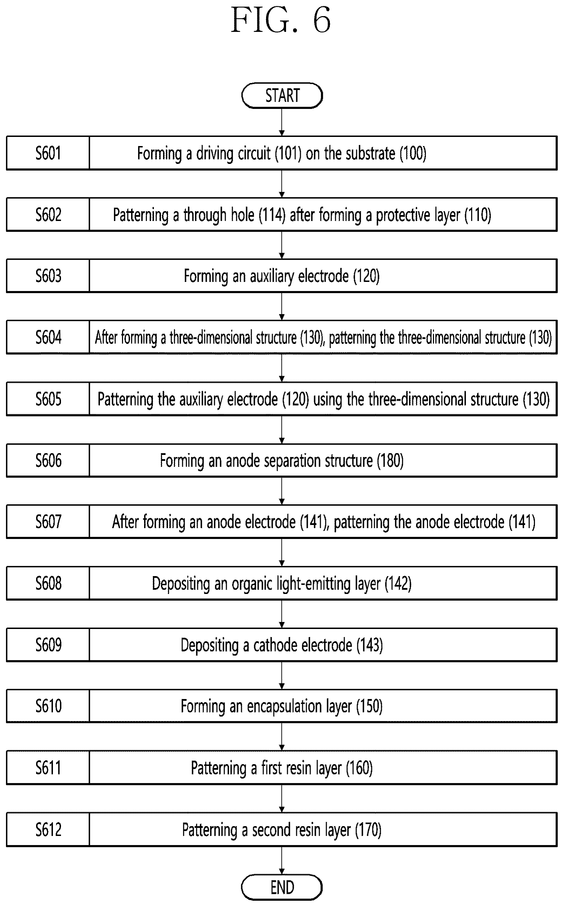

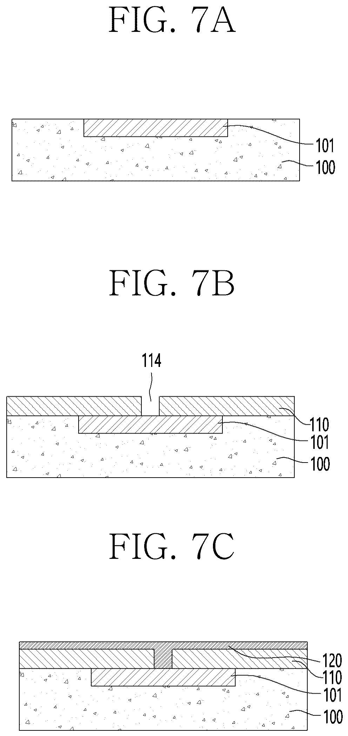

FIG. 6 is a flowchart explaining a manufacturing method of an organic light-emitting display device according to the first embodiment. FIGS. 7A to 7N are cross-sectional views showing a method of manufacturing an organic light-emitting display device according to a first embodiment.

The manufacturing method of the organic light-emitting display device according to the first embodiment will be described in detail with reference to FIGS. 1, 4, 6, and 7.

[S601 in FIG. 6]; As shown in FIG. 7A, a driving circuit 101 comprising a transistor and a capacitor can be formed on the substrate 100. A transistor, etc. can be formed on the substrate 100. That is, a transistor made of a silicon-based semiconductor material or an oxide-based semiconductor material can be formed on a glass substrate.

[S602 in FIG. 6]; As shown in FIG. 7B, after the protective layer 110 is formed, the through hole 114 can be patterned. The protective layer 110 can be formed of an inorganic layer, for example, a silicon oxide layer (SiOx), a silicon nitride layer (SiNx), or a multilayer thereof. Additionally, the protective layer 110 can comprise a polymer resin layer.

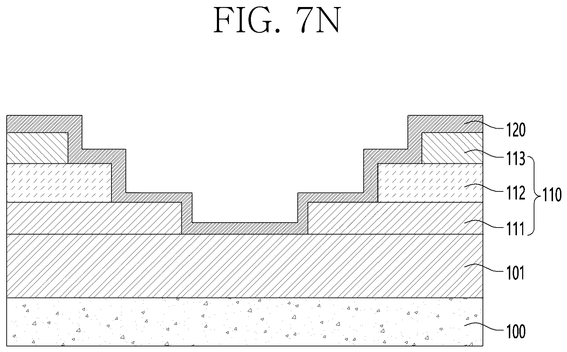

As shown in FIG. 7N, when the polymer resin layer is composed of a first protective film, the first protective film can be patterned to form a first through hole. After the inorganic film is formed on the first protective film, a second through hole can be formed having a width greater than the width of the first through hole. By repeatedly performing this process, the through hole 114 having a reflective three-dimensional structure 115 can be formed. The reflective three-dimensional structure 115 of the through hole 114 can improve the reflection performance of the second metal film (122 in FIG. 9) of the auxiliary electrode 120, thereby contributing to improving light extraction efficiency.

Accordingly, the auxiliary electrode 120 can be connected to the drain electrode of the transistor of the driving circuit 101 through the through hole 114 having the reflective three-dimensional structure 115 of the protective layer 110.

[S603 in FIG. 6]; As shown in FIG. 7C, the auxiliary electrode 120 comprising a first metal film, a second metal film, and a third metal film can be formed using a sputtering method. The auxiliary electrode 120 can be connected to the drain electrode of the transistor of the driving circuit 101 through the through hole 114 formed in the protective layer 110.

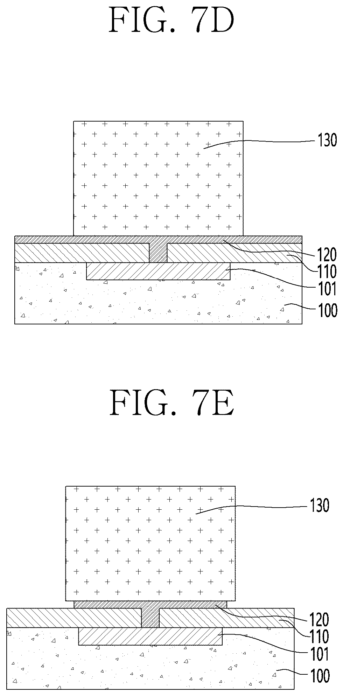

[S604 in FIG. 6]; As shown in FIG. 7D, the three-dimensional structure 130 can be formed on the auxiliary electrode 120. If the three-dimensional structure 130 is made of acrylic or polyimide resin, it can be patterned at once. If the three-dimensional structure 130 is made of red, green, and blue color resins, it can be patterned for each subpixel three times. If the three-dimensional structure 130 is made of an inorganic material, it can be patterned using a photolithography process and a dry etching process.

[S605 in FIG. 6]; As shown in FIG. 7E, the auxiliary electrode 120 can be patterned using the three-dimensional structure 130 as a mask. Depending on the type and structure of the auxiliary electrode 120 and/or the design of the anode separation structure 180, the auxiliary electrode 120 can be used for patterning using wet etching, dry etching, or a combination of the two. An ashing process can be added for patterning of the auxiliary electrode 120.

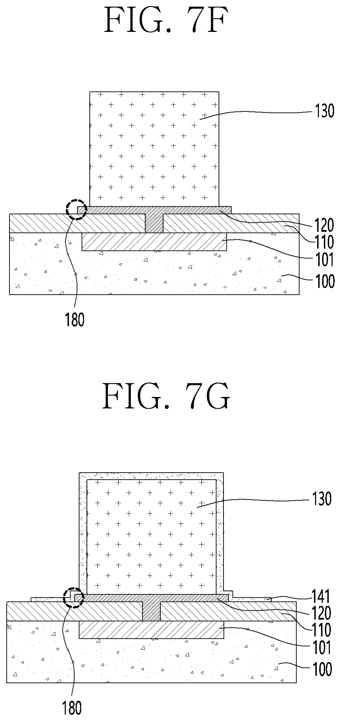

[S606 in FIG. 6]; As shown in FIG. 7F, an anode separation structure 180 can be formed. The anode separation structure 180 can be defined as a structure configured to electrically separate the anode electrodes 141 of adjacent subpixels.

Meanwhile, a part of the film included in the protective layer 110 can be again patterned by self-alignment with the auxiliary electrode 120 at the lower side of the auxiliary electrode 120 patterned by self-alignment with the three-dimensional structure 130. In the next process, that is, the anode electrode film forming process, the film can be configured to be divided rather than being connected laterally in a self-aligned manner, and this structure can also be defined as the anode separation structure 180. The anode separation structure 180 will be described in detail later in the second embodiment (FIGS. 8 and 9).

[S607 in FIG. 6]; As shown in FIG. 7G, the anode electrode 141 can be formed on the three-dimensional structure 130 and the anode separation structure 180 and then patterned. The anode electrode 141 can be formed by forming a film of a transparent conductive material TCO such as ITO or IZO that can transmit light using a sputtering method to a thickness of less than 50 nanometers.

A photoresist pattern can be formed on the anode electrode 141. The photoresist pattern can be covered with the three-dimensional structure 130 and the anode separation structure 180 in order to remove the anode electrode located between subpixels, the uncovered anode electrode 141 can be removed through a wet etching process to form the anode electrode 141, and then the photoresist pattern can be removed

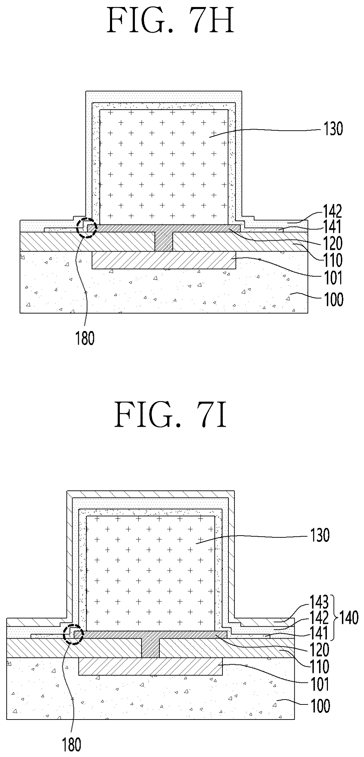

[S608 in FIG. 6]; As shown in FIG. 7H, the organic light-emitting layer 142 can be formed on the anode electrode 141. The organic light-emitting layer 142 can comprise a white light-emitting layer that emits white light. When the organic light-emitting layer 142 is a white light-emitting layer, it can be formed in a tandem structure of two or more stacks.

A charge generation layer can be formed between the organic light-emitting stacks. An organic light-emitting display device can be provided with at least two or more organic light-emitting stacks. As shown in FIG. 9, a charge generation layer 142b can be disposed between the first organic light-emitting stack 142a and the second organic light-emitting stack 142c. The charge generation layer 142b can comprise an n-type charge generation layer and a p-type charge generation layer.

Since the organic light-emitting layer 142 is formed by evaporation deposition, step coverage characteristics are poor. Therefore, the organic light-emitting layer 142 can penetrate into the inner wall of the undercut structure 181 of the anode separation structure 180 shown in FIG. 9. However, according to an embodiment, both the first organic light-emitting stack 142a and the first charge generation layer 142b can be formed to have disconnection portions at the entrance of the undercut structure 181. That is, each of the first organic light-emitting stack 142a and the first charge generation layer 142b can be disconnected at the entrance of the undercut structure 181. Therefore, not only the anode electrode 141 is separated by the undercut structure 181, but also the first charge generation layer 142b, which is a low-resistance material of the organic light-emitting layer 142, is disconnected, so that the influence of adjacent subpixels can be minimal due to leakage current through the organic light-emitting layer 142.

The method for forming both the first organic light-emitting stack 142a and the first charge generation layer 142b to have disconnection portions in S608 will be described in detail later with reference to the cross-sectional view of the anode separation structure 180 in FIG. 9.

[S609 in FIG. 6]; As shown in FIG. 7I, a cathode electrode 143 can be formed on the organic light-emitting layer 142. When the cathode electrode 143 is made of ITO, IZO, etc., the cathode electrode 143 can be formed by sputtering. When the cathode electrode 143 is made of magnesium Mg, silver Ag, etc., the cathode electrode 143 can be deposited using a vacuum deposition method.

Since the same voltage must be applied to the cathode electrode 143 as a common electrode for all of the plurality of pixels, the cathode electrode 143 of all pixels can be electrically connected. Therefore, it is very important to ensure that the anode separation structure 180 does not disconnect the cathode electrode 143. That is, the sputtering method has good step coverage, but the vacuum deposition method has poor step coverage, so that the setting of the deposition angle of the deposition source must be optimized to prevent disconnection due to the anode separation structure 180. The height H of the undercut must also not exceed a certain height to prevent disconnection of the cathode electrode.

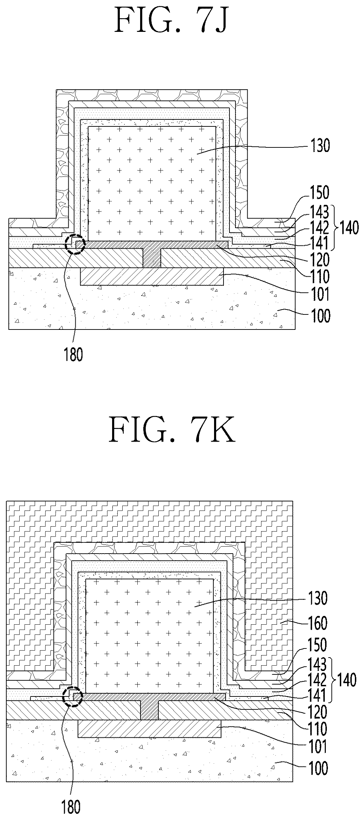

[S610 in FIG. 6]; As shown in FIG. 7J, an encapsulation layer 150 can be formed on the cathode electrode 143. The encapsulation layer 150 can serve to prevent oxygen or moisture from penetrating into the organic light-emitting layer 142 and the cathode electrode 143. To this end, the encapsulation layer 150 can comprise at least one inorganic layer and at least one organic layer.

For example, in the case of an inorganic film, a silicon oxide film or silicon nitride film formed by a PECVD method, a film formed by an atomic layer deposition (ALD) method, a film that can be formed by PECVD, or an alumina ($Al_2O_3$) film can be used. In the case of an organic film, epoxy resin, acryl resin, etc. can be used. An inorganic film can be formed on top of the organic film.

As shown in FIG. 7K, the first resin layer 160 can be formed on the encapsulation layer 150.

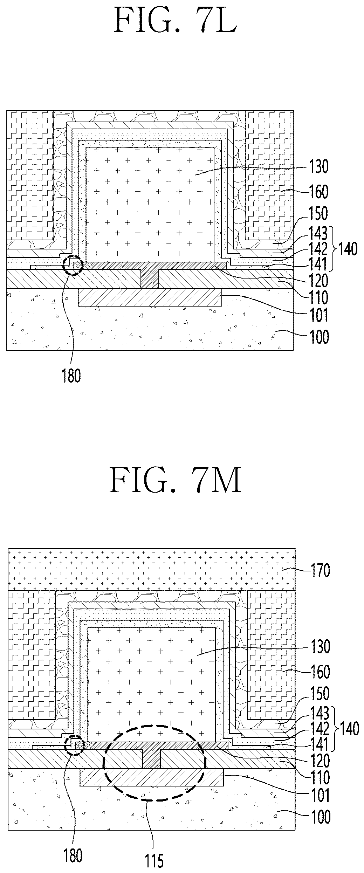

[S611 in FIG. 6]; As shown in FIG. 7L, the entire surface of the encapsulation layer 150 can be exposed to an appropriate amount of light and developed, so that the height of the three-dimensional structure 130 can remain, and the encapsulation layer 150 on the organic light-emitting device 140 corresponding to the upper side of the three-dimensional structure 130 can be removed. In this instance, in this case. the first resin layer 160 can be patterned in self-alignment by the three-dimensional structure 130, thereby minimizing alignment tolerance when using a mask. Areas other than subpixels can be removed by mask exposure.

[S612 in FIG. 6]; As shown in FIG. 7M, the second resin layer 170 can be formed on the first resin layer 160. The second resin layer 170 is disposed to correspond to each subpixel. For example, the second resin layer 170 can comprise a red resin layer, a green resin layer, and a blue resin layer. The red resin layer can be disposed to correspond to the red subpixel, the green resin layer can be disposed to correspond to the green subpixel, and the blue resin layer can be disposed to correspond to the blue subpixel.

The second resin layer 170 can be formed as a transparent film without using a color material. The transparent film can be, for example, acryl resin, epoxy resin, polyamide resin, polyimide resin, etc.

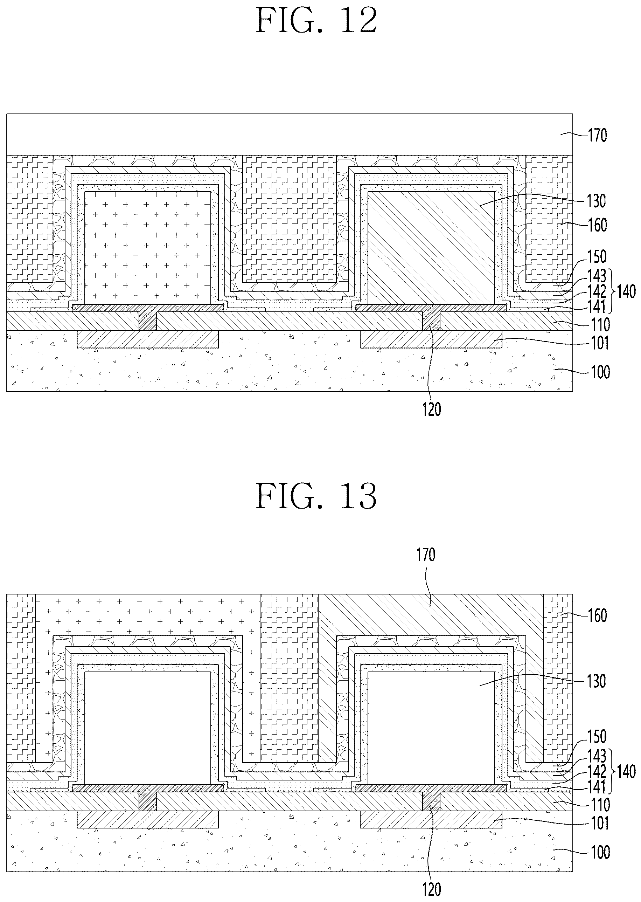

Meanwhile, FIG. 12 is a cross-sectional view showing an organic light-emitting display device according to a third embodiment. As shown in FIG. 12, transparent resin can be used as the second resin layer 170 instead of the color resin of the first embodiment (FIG. 7M). Accordingly, the brightness of the screen of the organic light-emitting display device can be improved. In addition to changing the type of material of the second resin layer 170, the performance of organic light-emitting display devices is mutually influenced according to the type of material of the three-dimensional structure 130 and the combination of the type and thickness of the anode electrode 141 and the cathode electrode 143 of the organic light-emitting device 140, respectively.

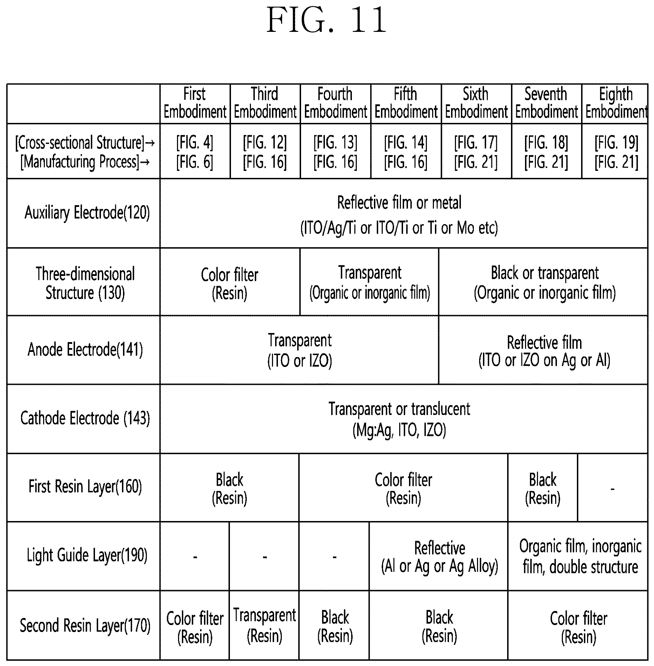

Therefore, a comprehensive approach is needed to improve image qualities while maximizing light extraction efficiency. FIG. 11 shows examples of various combinations according to this approach. The third to eighth embodiments shown in FIG. 11 will be described in detail later.

As described above, the manufacturing method of the organic light-emitting display device according to the first embodiment can comprise a step of forming a protective layer 110 on the substrate 100 comprising the driving circuit 101 and patterning through holes (S601 and S602), a step of forming the auxiliary electrode 120 (S603), a step of applying and patterning the red, green, and blue three-dimensional structures 130 (S604), a step of patterning the auxiliary electrode 120 using the pattern of the three-dimensional structure 130 (S605), a step of patterning the anode electrode 141 after forming a film (S607), a step of completing the organic light-emitting device 140 by depositing the organic light-emitting layer 142 and the cathode electrode 143 (S608 and S609), a step of forming the encapsulation layer 150 (S610), a step of patterning after applying the first resin layer 160 (S611), a step of patterning and forming the second resin layer 170 (S612), etc.

The step of forming the anode separation structure 180 (S606) can be included to the step of patterning the auxiliary electrode 120 (S605).

FIG. 8 is a flowchart explaining a method of manufacturing an organic light-emitting display device having an anode separation structure 180 according to the second embodiment. In FIG. 8, the description of the same process steps as in FIG. 6 is omitted. FIG. 9 is a cross-sectional view showing an example of an anode separation structure according to the second embodiment. FIG. 9 is an enlarged view of the anode separation structure 180 of FIG. 7M. 10A to 10G are cross-sectional views showing a method of manufacturing an organic light-emitting display device having an anode separation structure according to a second embodiment.

The anode separation structure 180 of the second embodiment can have a structure in which the anode electrode 141 is separated and the low-resistance layer of the organic light-emitting layer 142 is also disconnected. The low-resistance layer, which is the core factor affecting the leakage current between subpixels, can comprise a first organic light-emitting stack 142a comprising a hole injection layer (p-doped HTL) formed by direct contact with the anode electrode and a first charge generation layer 142b.

The manufacturing method of the anode separation structure 180 will be described with reference to FIGS. 8, 9, and 10A to 10J. The protective layer 110 can comprise a first protective film 111, a second protective film 112, a third protective film 113, etc. For example, the first protective film 111 can comprise a silicon nitride film (SiNx), the second protective film 112 can comprise a silicon oxide film (SiOx), and the third protective film 113 can comprise a silicon nitride film (SiNx). In addition, the first protective film 111, the second protective film 112, and the third protective film 113 can be formed on the driving circuit 101 in that order.

The auxiliary electrode 120 can comprise a first metal film 121, a second metal film 122, a third metal film 123, etc. For example, the first metal film 121 can be a metal that has good electrical contact characteristics with the driving circuit and is easy to dry etch, and can be formed of Ti, Mo, etc. The second metal film 122 can be a metal that has good reflective properties and is easily wet etched, and can be formed of Ag, Ag alloy, Al, etc. The third metal film 123 can be a conductive material that is transparent, has low contact resistance with the anode electrode 141, and has good process reliability, and can be formed of ITO, IZO, etc.

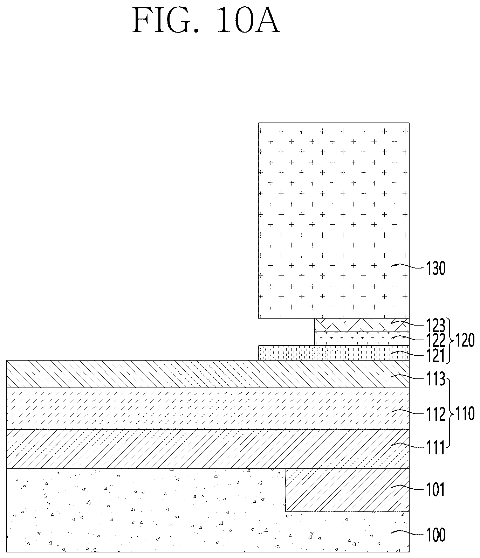

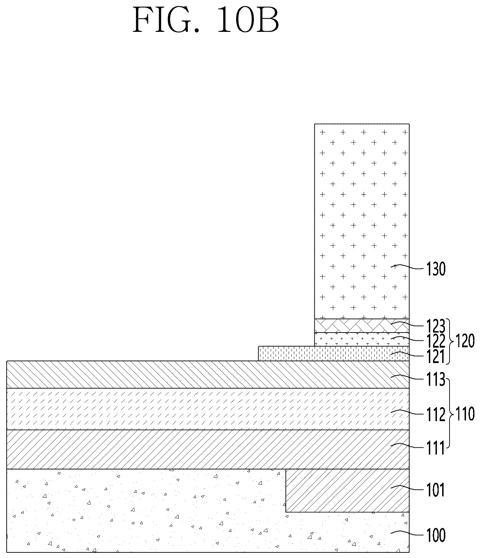

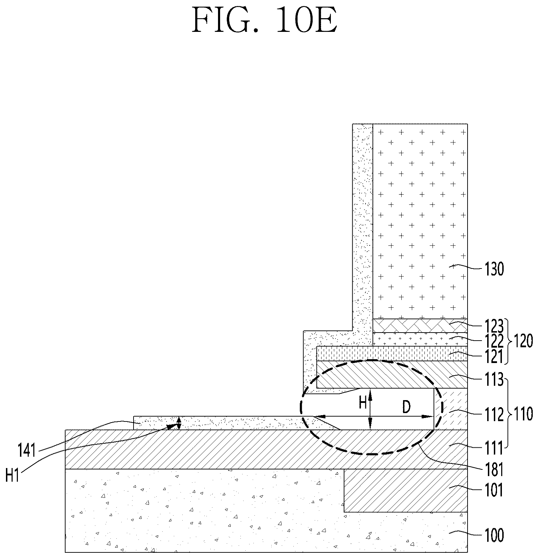

[S6061 in FIG. 8] As shown in FIG. 10A, the auxiliary electrode 120 can be patterned using the three-dimensional structure 130. The third metal film 123, the second metal film 122, and the first metal film 121 can be etched into various cross-sectional shapes depending on the etching characteristics of the material. FIG. 10A is an example of various cross-sectional shapes, and the embodiment is not limited thereto. As shown in FIG. 10B, a part of the poly-dimensional structure 130 can be removed through ashing or dry etching, and a part of the auxiliary electrode 120 recessed into the lower side of the poly-dimensional structure 130 can be exposed. Through this, an electrical contact area for connecting the anode electrode (141 in FIG. 10E) to the auxiliary electrode 120 can be secured in the next process.

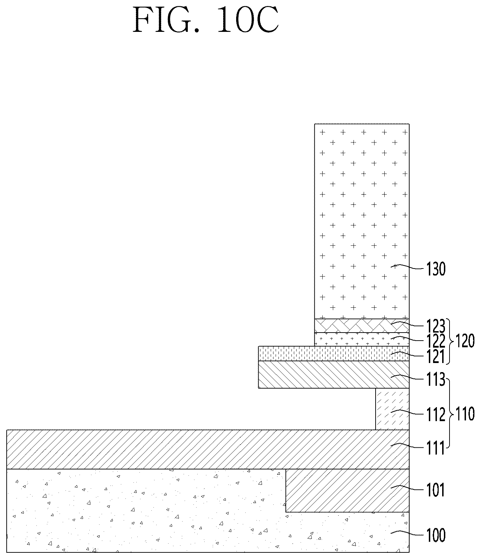

[S6062 in FIG. 8] If dry etching is continuously performed to etch the protective layer 110, it can be patterned as shown in FIG. 10C. At this time, the first protective film 111 must remain while dry etching is performed on the third protective film 113 and the second protective film 112. For example, in the case of a triple structure of a silicon nitride film and a silicon oxide film, the ratio of silicon to oxygen, the density of the film, etc. must be well set in the film formation stage, the ratio of silicon to nitrogen, and the type and composition ratio of the dry etching gas, etc. must be well set for each dry stage in the dry etching stage. To this end, the third protective film 113 can be formed of a silicon nitride film, and the second protective film 112 can be formed of a silicon oxide film. Additionally, the first protective film 111 can be formed of a resin film. For example, the resin film can be an organic film such as acryl resin, epoxy resin, phenolic resin, polyamide resin, or polyimide resin. Accordingly, the protective layer 110 can be composed of a triple structure, but can also be composed of more layers.

As another example, the third protective film 113 can be omitted and can be composed of a double structure of the second protective film 112 and the first protective film 111. For example, the first protective film 111 can be formed of a resin film, and the second protective film 112 can be formed of an inorganic film such as a silicon nitride film or a silicon oxide film. At this time, the undercut structure 181 can be easily formed by using the high etch selectivity between the resin film and the inorganic film. FIG. 9 shows a cross-sectional view of the results for this structure. Referring to FIG. 9, the etch surfaces of the second metal film 122 and the third metal film 123 of the auxiliary electrode 120 can be positioned on the same vertical line at approximately the level of several 100 nanometers. The anode electrode 141 can be connected to an upper surface of a protrusion portion of the first metal film 121 that protrudes within 2 micrometers of the auxiliary electrode 120 and the etched surface of each of the second metal film 122 and the third metal film 123.

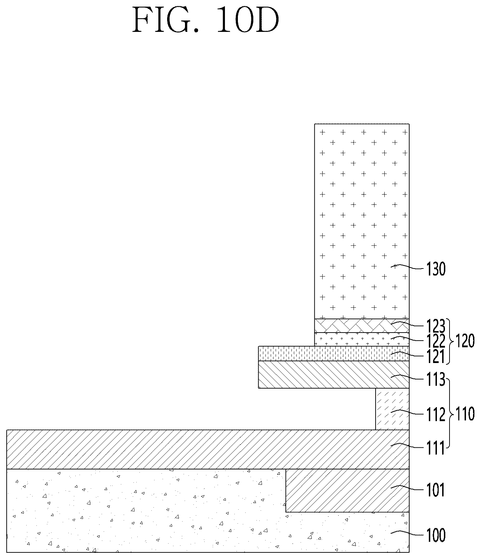

[S6063 in FIG. 8] As shown in FIG. 10D, the undercut structure 181 can be formed by etching the first protective film 111 and the second protective film 112 by applying an etching method with a high etch selectivity of the second protective film 112 with respect to the first protective film 111. In this case, it can be patterned into a cross-sectional structure as shown in FIG. 10D. For example, the first inorganic layer that is the first protective film 111 and the third inorganic layer that is the third protective film 113 can be formed of a silicon nitride layer, and the second inorganic layer that is the second protective film 112 can be formed of a silicon oxide layer. In this instance, selectivity can be secured with an HF-based etching solution. Alternatively, when the first protective film 111 is used as a resin film, the etching selectivity can be further increased by taking advantage of the fact that the resin film is difficult to etch in a wet etching solution, so that a cross-sectional structure as shown in FIG. 10D can be easily formed.

[S807 in FIG. 8] As shown in FIG. 10E, the anode electrode 141 can be formed on the three-dimensional structure 130 and the anode separation structure 180. The anode electrode 141 can be formed of a transparent conductive material such as ITO or IZO that can transmit light. The thickness H1 of the anode electrode 141 can be 50 nanometers or less. Accordingly, the undercut height H can be prevented from being reduced by the anode electrode 141 and the anode electrode 141 can be prevented from being connected without being separated.

As a result, the anode electrode 141 can be formed by surrounding the surface, that is, the side surface and the upper surface, of the three-dimensional structure 130 constituting the subpixel. The anode electrode 141 can be connected to the auxiliary electrode 120 protruding from the side surface of the three-dimensional structure 130, and thus can be connected to the driving circuit 101 through the auxiliary electrode 120. At this time, the anode electrode 141 can be disconnected from nearby subpixels by the undercut structure 181.

The anode electrode formed in each subpixel can be disconnected from the anode electrode formed between adjacent subpixels and in areas other than pixels comprising a plurality of subpixels. At this time, the anode electrode formed between adjacent subpixels and in areas other than pixels comprising a plurality of subpixels can be left as is. Alternatively, after forming a pattern with photolithography, unnecessary anode electrodes not covered by the photoresist pattern can be removed by wet etching. After the anode electrode 141 is formed, the photoresist pattern can be removed.

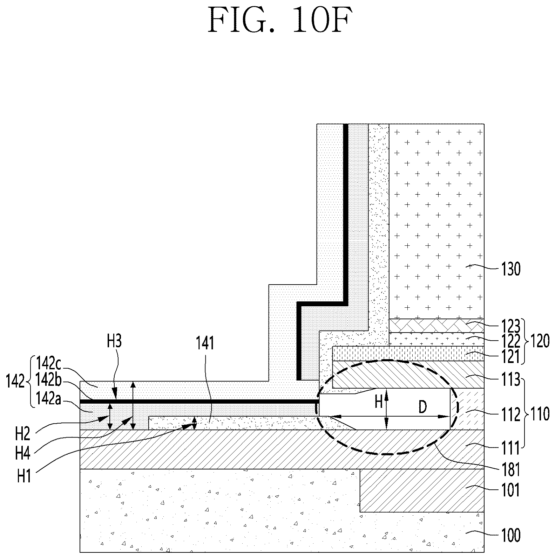

[S808 in FIG. 8] As shown in FIG. 10F, the organic light-emitting layer 142 can be formed on the anode electrode 141. The organic light-emitting layer 142 can comprise a white light-emitting layer that emits white light. When the organic light-emitting layer 142 is a white light-emitting layer, it can be formed in a tandem structure of two or more stacks. A charge generation layer can be formed between the stacks. The charge generation layer 142b can comprise an n-type charge generation layer and a p-type charge generation layer.

The anode separation structure can ensure that not only the anode electrode 141 but also the first organic light-emitting stack 142a and the first charge generation layer 142b are disconnected, and the cathode electrode 143 can have a horizontally-connected structure. The core idea of the anode separation structure is a structure that separates the anode electrode 141 and the organic light-emitting layer 142 at the same location.

Since the organic light-emitting layer 142 is formed by evaporation deposition, step coverage characteristics are poor, so that the organic light-emitting layer 142 can penetrate into the inner wall of the undercut structure 181 shown in FIG. 9. However, according to an embodiment, both the first organic light-emitting stack 142a and the first charge generation layer 142b can be formed to have disconnection portions at the entrance of the undercut 181. That is, each of the first organic light-emitting stack 142a and the first charge generation layer 142b can be disconnected at the entrance of the undercut structure 181. Therefore, not only is the anode electrode 141 separated by the undercut structure 181, but the first charge generation layer 142b, which is a low-resistance material of the organic light-emitting layer 142, is disconnected, so that the influence of adjacent subpixels can be minimal due to leakage current through the organic light-emitting layer 142.

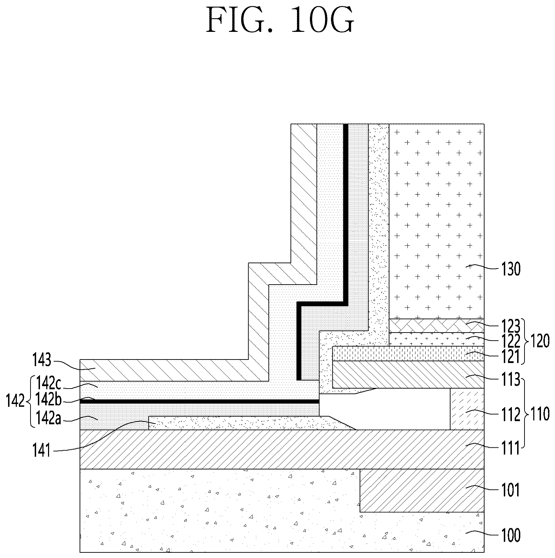

As shown in FIG. 10G, the cathode electrode 143 can be formed on the organic light-emitting layer 142.

Meanwhile, as shown in FIGS. 10F and 10G, the height H of the undercut structure 181 can be at least greater than the sum of the thickness H1 of the anode electrode 141, the thickness H2 of the first organic light-emitting stack, and the thickness H3 of the first charge generation layer. In addition, since the cathode electrode 143 must be electrically connected to each subpixel, the height H of the undercut structure 181 can be less than the sum of the total thickness H4 of the organic light-emitting layer 142 and the thickness H1 of the anode electrode 141.

Therefore, in order for the anode electrode 141 not to be connected to the first organic light-emitting stack 142a and the first charge generation layer 142b and the cathode electrode 143 to be connected to the second organic light-emitting stack 142c, etc., the following equation 1 can be satisfied. The depth D of the undercut structure 181 can be one or more times the height H of the undercut structure 181 in consideration of process deviation. Accordingly, each of the first organic light-emitting stack 142a and the first charge generation layer 142b can be disconnected by the anode separation structure, and process deviation can also be considered. This can be formalized as Equation 1.

[Equation 1]

$$H1+H2+H3 < H < H1+H4$$

For example, in a two-stack structure,

Thickness H1 of anode electrode 141: 50 nanometers

Thickness H2 of the first organic light-emitting stack: 150 nanometers

Thickness H3 of the first charge generation layer 142b: 20 nanometers

Total thickness H4 of organic light-emitting layer 142: 450 nanometers

When applying them, the height H of the undercut structure 181 can be 220 nanometers to 500 nanometers, and the depth D of the undercut structure 181 can be greater than 220 nanometers to 500 nanometers.

In the three-stack structure, 'H2+H3' in Equation 1 can be a thickness comprising all of the first organic light-emitting stack, the second organic light-emitting stack, the first charge generation layer, and the second charge generation layer. Additionally, the thickness of the a plurality of stack structures can be defined based on the thickness H4 of the organic light-emitting element 140 disposed on the side surface of the three-dimensional structure 130. This is because the thickness of the organic light-emitting element 140 disposed on the upper side and the side surface of the three-dimensional structure 130 can vary and the anode separation structure 180 can be positioned to be in contact with the side surface of the three-dimensional structure 130, so that it is reasonable to use the organic light-emitting device 140 disposed on the side surface of the three-dimensional structure 130 as a reference.

FIG. 11 is a table explaining the materials or material characteristics of the components that make up each of the first to eighth embodiments.

The third to eighth embodiments shown in FIG. 11 can be embodiments in which some of the components of the first embodiment are replaced or newly added. In addition to these, many more embodiments are possible through many more combinations.

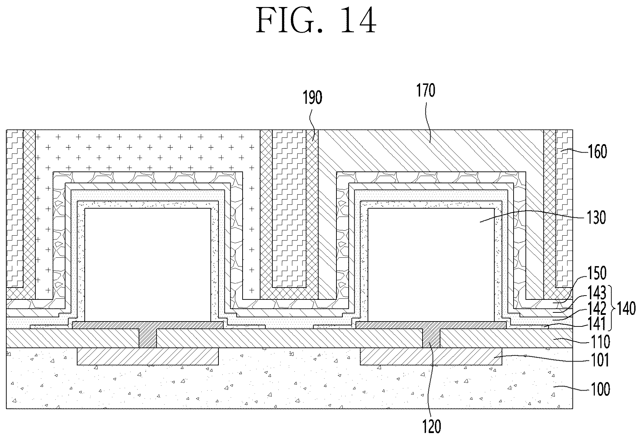

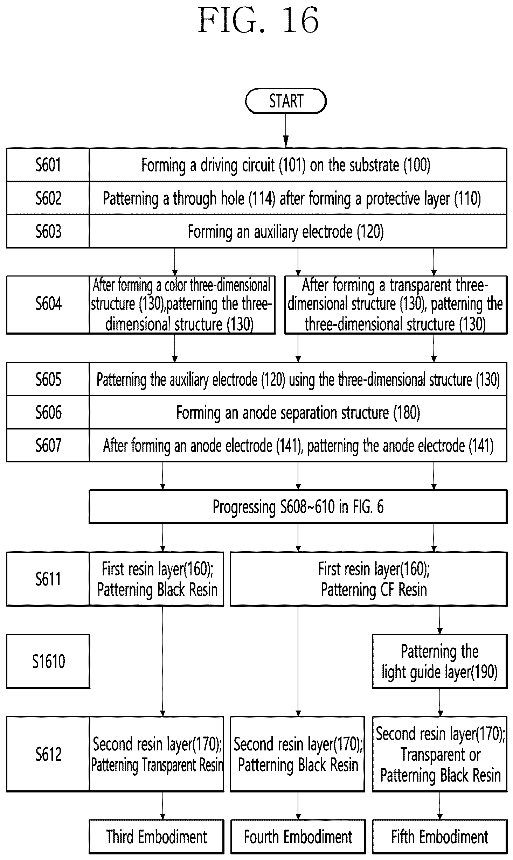

Meanwhile, FIG. 12 is a cross-sectional view showing an organic light-emitting display device according to a third embodiment. FIG. 13 is a cross-sectional view showing an organic light-emitting display device according to a fourth embodiment. FIG. 14 is a cross-sectional view showing an organic light-emitting display device according to a fifth embodiment. FIG. 16 is a flowchart illustrating a method of manufacturing an organic light-emitting display device according to third to fifth embodiments.

For example, unlike the first embodiment in which the second resin layer 170 is formed of a color resin, the second resin layer 170 can be formed of transparent resin as shown in FIGS. 12 and 16. Accordingly, the number of color filter processes can be reduced, material costs and investment costs can be reduced, and luminance can be improved.

For example, as shown in FIGS. 13 and 16, the three-dimensional structure 130 can be formed of a transparent inorganic film such as a silicon oxide film or a silicon nitride film, or a transparent polyimide-based resin or acrylic resin. The organic light-emitting element 140 can be disposed on the surface, that is, the side surface and the upper surface of the three-dimensional structure 130. An encapsulation layer 150 can be disposed on the organic light-emitting element 140, and a first resin layer 160 made of color filter resin can be formed on the encapsulation layer 150. The second resin layer 170 made of black resin can be disposed between subpixels, thereby preventing light leakage.

For example, as shown in FIGS. 14 and 16 (S1610), a light guide layer 190 can be formed on the front surface of a reflective metal such as aluminum Al, silver Ag, or Ag alloy. After filling the patterned and remaining valley areas of the first resin layer 160 between subpixels with the second resin layer 170 made of black resin, the light guide layer 190 in the area without the second resin layer 170 can be removed. In the case of the fifth embodiment, the light emitted from the organic light-emitting device 140 may be not absorbed by the second resin layer 170 but be reflected and emitted while being guided upward, so that light extraction efficiency can be improved.

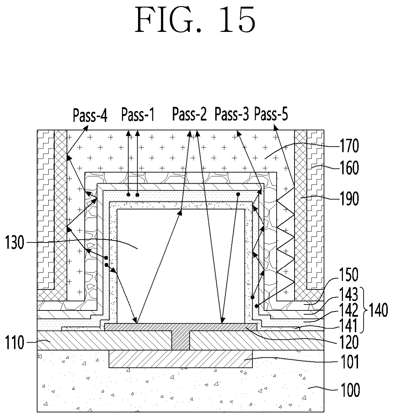

FIG. 15 shows a light path when the organic light-emitting element emits light in the organic light-emitting display device according to the fifth embodiment. The light guide layer 190 can totally reflect the light emitted from the side surface of the three-dimensional structure 130 and guide the reflected light toward an upper direction.

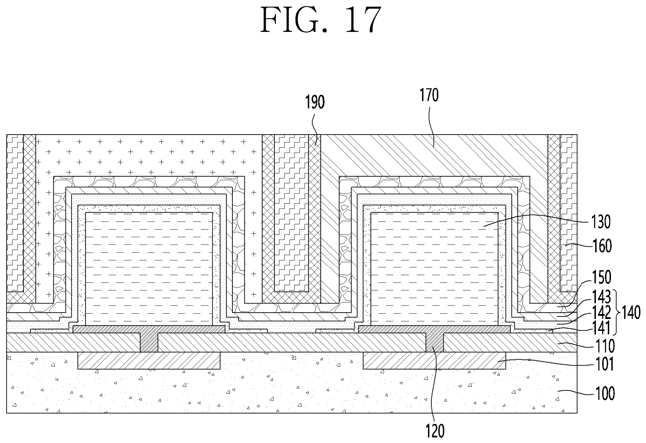

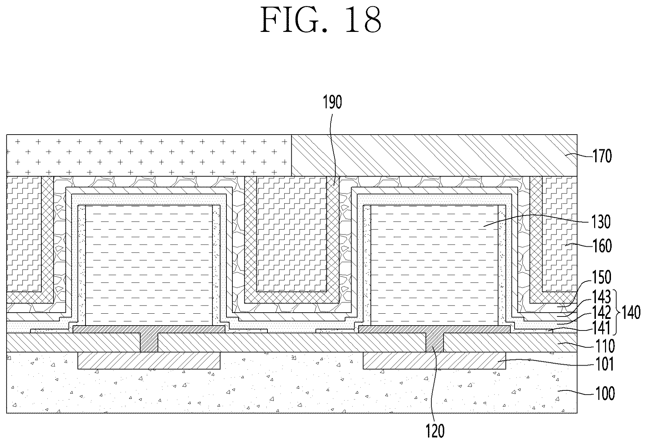

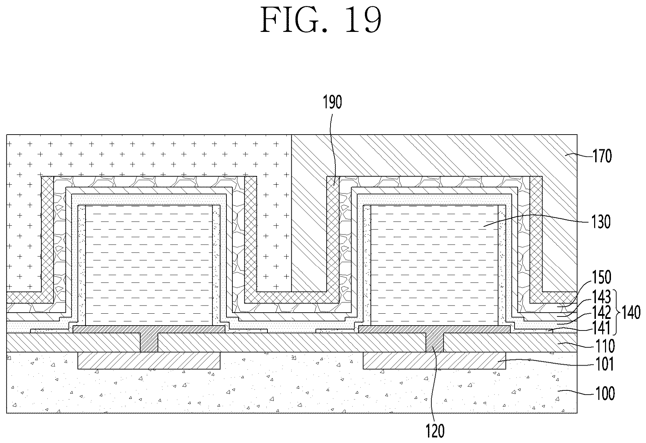

Meanwhile, FIG. 17 is a cross-sectional view showing an organic light-emitting display device according to the sixth embodiment. FIG. 18 is a cross-sectional view showing an organic light-emitting display device according to the seventh embodiment. FIG. 19 is a cross-sectional view showing an organic light-emitting display device according to an eighth embodiment.

As shown in FIG. 17, the light guide layer 190 can be disposed on the side surface of the three-dimensional structure 130. An encapsulation layer 150 can be disposed between the organic light-emitting element 140 and the light guide layer 190. In the sixth to eighth embodiments, the anode electrode 141 can be formed of a reflective metal. Light emitted from the organic light-emitting element 140 can be emitted only in an external direction of the three-dimensional structure 130. In particular, in the sixth embodiment (FIG. 17), the three-dimensional structure 130 does not need to be formed of a color resin or transparent resin, but can be formed of resin that is easy to process. In common with the sixth to eighth embodiments, the auxiliary electrode 120 can be formed in a structure of a reflective film. The three-dimensional structure 130 on the auxiliary electrode 120 can be formed of black resin. An anode electrode 141 can be formed on the surface of the three-dimensional structure 130. The anode electrode 141 can have a double structure consisting of a second layer having a transparent conductive film such as ITO, IZO, etc. on a first layer containing aluminum Al, silver Ag, Ag alloy, etc. An organic light-emitting element 140 composed of two or more stacks of light-emitting layers can be disposed on the anode electrode 141, and the cathode electrode 143 included in the organic light-emitting element 140 can be formed of a transparent conductive film such as ITO, IZO, etc.

In the subsequent processes and structures, the structures of the first resin layer 160, the light guide layer 190, and the second resin layer 170 in the sixth embodiment are the same as those described in the fifth embodiment.

As shown in FIGS. 18 and 19, in the seventh and eighth embodiments, the anode electrode 141 formed on the upper surface of the three-dimensional structure 130 can be removed. That is, the anode electrode 141 can be formed on the side surface of the three-dimensional structure 130. This is because it is difficult to simultaneously manage the thickness of each of the upper surface and the side surface of the three-dimensional structure 130 in the organic material deposition process, and as higher resolution increases, making good use of the light emitted from the side surface of the three-dimensional structure 130 is effective in increasing light extraction efficiency.

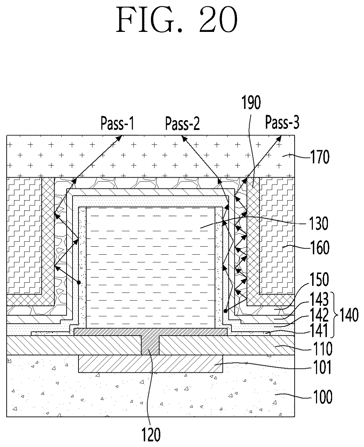

FIG. 20 shows a light path when the organic light-emitting element emits light in the organic light-emitting display device according to the seventh embodiment.

As shown in FIG. 20, the anode electrode 141 on the upper surface of the three-dimensional structure 130 can be removed, and light can be emitted only from the organic light-emitting layer 142 in contact with the anode electrode 141 on the side surface of the three-dimensional structure 130. The light emitted from the organic light-emitting layer 142 on the side surface of the three-dimensional structure 130 can be reflected multiple times at the interface between the light guide layer 190, the cathode electrode 143, the anode electrode 141, and the encapsulation layer 150, and be guided toward an upper direction of the three-dimensional structure 130.

Meanwhile, a first resin layer 160 formed of black resin between subpixels, that is, between the light guide layer 190 of each subpixel located between the three-dimensional structures 130 can be disposed. In addition, the three-dimensional structure 130 can also be formed of black resin. Accordingly, the light emitted from the organic light-emitting element 140 can be guided only vertically toward an upper direction while being reflected multiple times between the anode electrode 141 and the light guide layer. Accordingly, light extraction efficiency can be improved and luminance can be increased.

In the case of this structure, in order to guide light only toward an upper direction, the auxiliary electrode 120 can be formed as a reflective structure. The auxiliary electrode 120 can guide light from a lower direction toward an upper direction, like the optical path Pass-2 in FIG. 20. Additionally, when the auxiliary electrode 120 is formed of a reflective metal, the contrast ratio characteristic can be lowered by light incident from the outside, so that a polarizer needs to be added. However, according to the embodiment, the three-dimensional structure 130 can be formed of black resin, so that there is no need to add a polarizer. In particular, in the seventh and eighth embodiments, except for the area where the light is emitted, it can be made of black resin, and the area where the light is emitted can be also emitted only from a cross section the size of the thickness of the organic light emitting device 140, so that it is possible to implement display characteristics with close to infinite contrast ratio characteristics even without adding a polarizer.

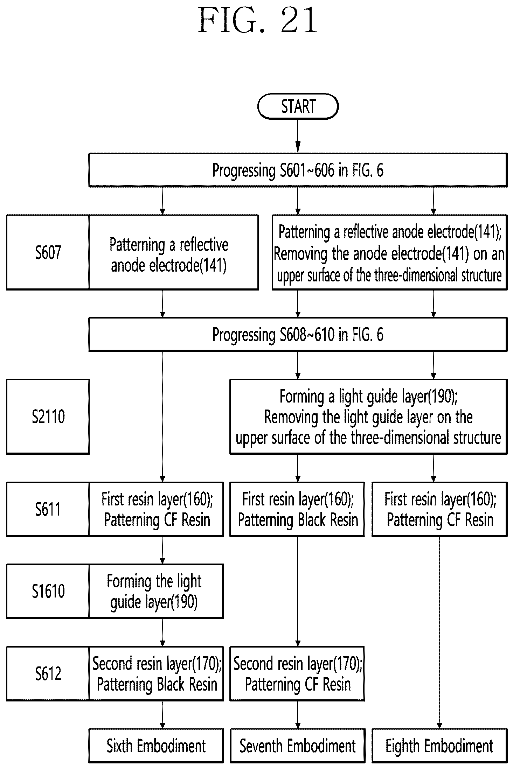

FIG. 21 is a flowchart explaining a manufacturing method of an organic light-emitting display device according to the sixth to eighth embodiments. In FIG. 21, the description of the same process steps as in FIG. 6 is omitted.

Only added processes not included in the first to fifth embodiments are described, and the first to fifth embodiments can be referred to for missing descriptions.

Referring to S607 of FIG. 21, in the case of the seventh and eighth embodiments, in the step of patterning the reflective anode electrode 141, the anode electrode 141 on the upper surface of the three-dimensional structure 130 can be optionally removed. The anode electrode 141 in the seventh and eighth embodiments can be made of Ag or Ag alloy with a reflective function. The anode electrode 141 can have a double structure of a transparent conductive film such as ITO or IZO on an Al reflective film. The anode electrode 141 can have a triple structure in which a transparent conductive film is added to the lower side of the reflective film of the double structure layer. After the photosensitive resin is applied on the anode electrode 141, the entire surface can be exposed with an appropriate amount of light and developed to remove the photosensitive resin on the supper side of the three-dimensional structure 130, leaving as much as the height of the three-dimensional structure 130. In this instance, since the three-dimensional structure 130 and the photosensitive resin are patterned by self-alignment, alignment tolerance when using a mask can be minimized. In the subsequent process, the anode electrode 141 disposed on the upper surface of the three-dimensional structure 130 on which the photosensitive resin is not applied can be removed using an etching process. Areas other than subpixels can be removed with mask exposure.

In the case of the seventh and eighth embodiments in S2110 of FIG. 21, in order to ensure that total reflection occurs at the angle of incidence in as many areas as possible at the interface between the light guide layer 190 and the encapsulation layer 150, the light guide layer 190 can be formed of a material of the encapsulation layer 150 that is 0.2 or more smaller than the refractive index of the encapsulation layer 150 in contact with the light guide layer 190.

In order to allow reflection again even if total reflection does not occur at the interface between the light guide layer 190 and the encapsulation layer 150, it can be formed as a double structure in which a metal film with good reflectivity is added to the light guide layer 190. The light guide layer on the upper surface of the three-dimensional structure 130 can be removed in S2110.

The embodiment can be adopted in display field that display image or information. The embodiment can be adopted in display field that display image or information using an organic light-emitting element.

For example, the embodiment can be adopted for an HMD-type display. In addition, the embodiment can comprise TV, signage, mobile terminal such as mobile phone and smart phone, display for computer such as laptop and desktop, head-up display (HUD) for automobile, backlight unit for display, display for extend reality (XR) such as AR, VR, mixed reality (MR), etc, light source, etc.

The above-described embodiment is an example, and free modification is possible within the scope included in the spirit. Accordingly, the embodiments include modifications within the scope of the appended claims and their equivalents.

## Claims

1. An organic light-emitting display device, comprising:

   a substrate comprising a plurality of pixels, each of the plurality of pixels comprising a plurality of subpixels;
   an auxiliary electrode in each of the plurality of subpixels;
   a three-dimensional structure on the auxiliary electrode;
   an organic light-emitting element surrounding the three-dimensional structure;
   an encapsulation layer surrounding the organic light-emitting element; and
   a resin layer on the encapsulation layer,
   wherein the organic light-emitting element comprises:

   an anode electrode surrounding an upper surface and a side surface of the three-dimensional structure and is connected to the auxiliary electrode through the side surface of the three-dimensional structure;
an organic light-emitting layer on the anode electrode; and
a cathode electrode on the organic light-emitting layer.

2. The organic light-emitting display device of claim 1, wherein the auxiliary electrode has a triple structure comprising a first metal film, a second metal film, and a third metal film, a triple structure comprising the first metal film, the third metal film, and the second metal film, a double structure comprising the second metal film and the third metal film, or a single structure comprising one of the first metal film, the second metal film, and the third metal film.

3. The organic light-emitting display device of claim 1, wherein the three-dimensional structure is composed of a polymer material or a transparent inorganic film, and
wherein when the three-dimensional structure is the polymer material, the three-dimensional structure comprises a polymer material or a transparent polymer material in which red, green, and blue pigments are dispersed for each subpixel.

4. The organic light-emitting display device of claim 2 or 3, wherein a distance from an end of a corner of a lower surface of the three-dimensional structure to an end of a corner of the auxiliary electrode is the same along the perimeter of the three-dimensional structure.

5. The organic light-emitting display device of claim 4, wherein the distance from the edge of the lower surface of the three-dimensional structure to the edge of the auxiliary electrode is within 2 micrometers, and it is protruding or recessed from the edge of the lower surface of the three-dimensional structure.

6. The organic light-emitting display device of claim 1, wherein the three-dimensional structure has a tetrahedral shape, a hexahedral shape, an octahedron shape, a cylindrical shape, a hemispheric or semi-elliptical shape, a shape where an inner diameter decreases toward an upper side, or a combination thereof,

   wherein a lower surface of the three-dimensional structure is in contact with the auxiliary electrode,
   wherein an inclination of the side surface with respect to the lower surface of the three-dimensional structure is 60 degrees to 90 degrees, and
   wherein the inclination is maintained up to the upper surface of the three-dimensional structure, or increases or decreases within the inclination and extends to the upper surface of the three-dimensional structure.

7. The organic light-emitting display device of claim 6, wherein the three-dimensional structure has a same shape for subpixels having a same color, and has different shapes for subpixels having different colors.

8. The organic light-emitting display device of claim 7, wherein the pixel comprises a first sub-pixel, a second sub-pixel, and a third sub-pixel,

wherein the first sub-pixel and the second sub-pixel comprise an octahedral three-dimensional structure, and
wherein the third sub-pixel comprises a tetrahedral three-dimensional structure.

9. The organic light-emitting display device of claim 1, comprising:

a driving circuit below the auxiliary electrode; and
a protective layer comprising two or more protective films between the auxiliary electrode and the driving circuit,
wherein the protective layer comprises a through hole having a reflective three-dimensional structure formed in the protective layer, and the driving circuit formed by the above two or more protective films, and
wherein the driving circuit is connected to the auxiliary electrode through the through hole.

10. The organic light-emitting display device of claim 1, wherein the organic light-emitting layer comprises a plurality of organic light-emitting stacks,

wherein the organic light-emitting stack comprises a charge generation layer,
wherein the anode electrode has a transparent conductive film such as ITO or IZO,
wherein the cathode electrode has a transparent conductive film such as ITO or IZO, a semitransparent conductive film such as Mg:Ag alloy, or a double structure combining thereof.

11. The organic light-emitting display device of claim 1, wherein the encapsulation layer has a triple structure or a single structure,
wherein the triple structure comprises:

a first encapsulation film which is an inorganic film such as an alumina, a silicon nitride film, a silicon oxide film, or an inorganic film double structure combining the inorganic films;

a second encapsulation film composed of an organic film on the first encapsulation film; and
a third encapsulation film having a same configuration as the first encapsulation film on the second encapsulation film, and
wherein the single structure is formed by the first encapsulation film.

12. The organic light-emitting display device of claim 1, wherein the resin layer comprises a color filter resin, a black resin, or a transparent resin.

13. The organic light-emitting display device of claim 12, wherein the resin layer comprises:

a first resin layer; and
a second resin layer on an upper side of the first resin layer,
wherein the first resin layer comprises the black resin, and
wherein the second resin layer comprises the color filter resin or the transparent resin.

14. An organic light-emitting display device, comprising:

a substrate comprising a plurality of pixels, each of the plurality of pixels comprising a plurality of subpixels,
wherein each of the plurality of subpixels comprises:

a driving circuit;
a protective layer disposed on the driving circuit and comprising two or more protective films;
an auxiliary electrode disposed on the protective layer and connected to the driving circuit through a through-hole of the protective layer;
an anode separation structure provided along a perimeter of the auxiliary electrode;
a three-dimensional structure on the auxiliary electrode;
an organic light-emitting element surrounding the three-dimensional structure;
an encapsulating layer surrounding the organic light-emitting element; and
a resin layer on the encapsulating layer,
wherein the organic light-emitting element comprises:

an anode electrode surrounding an upper surface and a side surface of the three-dimensional structure and connected to the auxiliary electrode through the side surface of the three-dimensional structure;
an organic light-emitting layer on the anode electrode; and

a cathode electrode on the organic light-emitting layer, and

wherein the anode separation structure has an undercut structure formed along perimeter of an edge of the auxiliary electrode such that an end of each of the two or more protective films are differently positioned to disconnect the anode electrode.

15. The organic light-emitting display device of claim 14, wherein the auxiliary electrode has a same shape as a lower surface of the three-dimensional structure,

wherein a distance from an end of a corner of the auxiliary electrode to an end of a corner of the lower surface of the three-dimensional structure is 2 micrometers or less, and

wherein the distance is the same along a perimeter of the three-dimensional structure.

16. The organic light-emitting display device of claim 14, wherein the protective layer has a triple structure comprising a first protective film, a second protective film, and a third protective film,

wherein the first protective film comprises a silicon nitride film (SiNx) or a polymer resin layer,

wherein the second protective film comprises a silicon oxide film (SiOx), and

wherein the third protective film comprises a silicon nitride film (SiNx.

17. The organic light-emitting display device of claim 14, wherein the protective layer has a triple structure comprising a first protective film, a second protective film, and a third protective film,

wherein the first protective film comprises a silicon oxide film (SiOx) or a polymer resin layer,

wherein the second protective film comprises a silicon nitride film (SiNx), and

wherein the third protective film comprises a silicon oxide film (SiOx).

18. The organic light-emitting display device of claim 14, wherein the protective layer has a double structure comprising a first protective film and a second protective film,

wherein the first protective film comprises a polymer resin, and

wherein the second protective film comprises a silicon nitride film (SiNx) or a silicon oxide film (SiOx).

19. The organic light-emitting display device of one of claims 14 to 18, wherein the organic light-emitting layer comprises a plurality of organic light-emitting stacks,

wherein the organic light-emitting stack comprises a charge generation layer,

wherein a height of the undercut structure is greater than a sum of a thickness of the anode electrode, a thickness of a first organic light-emitting stack, and a thickness of the first charge generation layer of the first organic light-emitting stack, and is less than a sum of a total thickness of the organic light-emitting layer and a thickness of the anode electrode, and

wherein a depth of the undercut structure is at least or more 1 time a height of the undercut structure.

20. The organic light-emitting display device of claim 19, wherein the anode electrode is horizontally disconnected from the first organic light-emitting stack and the first charge generation layer at a position that is horizontally disconnected from the anode electrode of the adjacent subpixel, and

wherein the cathode electrode is horizontally electrically connected to the cathode electrode of the adjacent subpixel at the disconnected position.

21. An organic light-emitting display device, comprising:

a substrate comprising a plurality of pixels, each of the plurality of pixels comprising a plurality of subpixels,

wherein each of the plurality of subpixels comprises:

an auxiliary electrode;

a three-dimensional structure on the auxiliary electrode;

an organic light-emitting element surrounding the three-dimensional structure;

an encapsulating layer surrounding the organic light-emitting element;

a light guide layer on the encapsulating layer; and

a resin layer on the encapsulating layer,

wherein the organic light-emitting element comprises:

an anode electrode surrounding a side surface of the three-dimensional structure and connected to the auxiliary electrode through a side surface of the three-dimensional structure;

an organic light-emitting layer on the anode electrode; and

a cathode electrode on the organic light-emitting layer, and

wherein the light guide layer is disposed on a side surface of the three-dimensional structure.

22. The organic light-emitting display device of claim 21, wherein the three-dimensional structure is composed of an opaque polymer material having a transmittance of 10% or less, and
wherein the anode electrode has a triple structure comprising a first transparent conductive film such as ITO or IZO; a reflective metal film such as Al, Ag, or Ag alloy on the first transparent conductive film; and a second transparent conductive film such as ITO or IZO on the reflective metal film, or a double structure comprising the reflective metal film and the second transparent conductive film on the reflective metal film.

23. The organic light-emitting display device of claim 21, wherein the encapsulation layer has a triple structure comprising a first encapsulation film having a single film of alumina, silicon nitride, or silicon oxide, or an inorganic film double structure combining the single films; a second encapsulation film made of an organic film on the first encapsulation film; and a third encapsulation film made of a same material as the first encapsulation film on the second encapsulation film, or has a single structure comprising the first encapsulation film.

24. The organic light-emitting display device of claim 21, wherein the light guide layer has a single structure comprising a reflective metal film such as Ag or Al, or has a double structure comprising an organic film or inorganic film having a refractive index 0.2 or more lower than that of the encapsulation film included in the encapsulation layer and in contact with the light guide layer, and the reflective metal film on the organic film or inorganic film.

25. The organic light-emitting display device of one of claims 21 to 24, wherein the organic light-emitting element is configured to emit light from the side surface of the three-dimensional structure, and
wherein the emitted light is configured to be guided upward while being reflected multiple times at an interface between layers or films arranged between the light guide layer and the three-dimensional structure.

26. The organic light-emitting display device of claim 21, wherein the three-dimensional structure comprises a black resin,

wherein the resin layer comprises a first resin layer and a second resin layer,
wherein the first resin layer comprises a black resin between the three-dimensional structures of each adjacent subpixel,
wherein the light guide layer is disposed between the first resin layer and the encapsulation layer, and
wherein the second resin layer is disposed on the encapsulation layer disposed on the three-dimensional structure.

# FIG. 1

# FIG. 2A

# FIG. 2B

FIG. 2C

FIG. 2D

FIG. 2E

FIG. 2F

FIG. 2G

FIG. 2H

FIG. 2I

# FIG. 3

Subpixel(103)

One Pixel(102)

130-1

130-2

130-5

130-3

130-4

# FIG. 4

# FIG. 5

Pass-1 Pass-2 Pass-3 Pass-4

Pass-5

170
160
150
143
142 } 140
141
120
110
101
100

# FIG. 6

START

| S601 | Forming a driving circuit (101) on the substrate (100) |
|------|--------------------------------------------------------|

| S602 | Patterning a through hole (114) after forming a protective layer (110) |
|------|------------------------------------------------------------------------|

| S603 | Forming an auxiliary electrode (120) |
|------|--------------------------------------|

| S604 | After forming a three-dimensional structure (130), patterning the three-dimensional structure (130) |
|------|------------------------------------------------------------------------------------------------------|

| S605 | Patterning the auxiliary electrode (120) using the three-dimensional structure (130) |
|------|---------------------------------------------------------------------------------------|

| S606 | Forming an anode separation structure (180) |
|------|---------------------------------------------|

| S607 | After forming an anode electrode (141), patterning the anode electrode (141) |
|------|------------------------------------------------------------------------------|

| S608 | Depositing an organic light-emitting layer (142) |
|------|--------------------------------------------------|

| S609 | Depositing a cathode electrode (143) |
|------|--------------------------------------|

| S610 | Forming an encapsulation layer (150) |
|------|--------------------------------------|

| S611 | Patterning a first resin layer (160) |
|------|--------------------------------------|

| S612 | Patterning a second resin layer (170) |
|------|---------------------------------------|

END

FIG. 7A

101
100

FIG. 7B

114

110
101
100

FIG. 7C

120
110
101
100

# FIG. 7D

130
120
110
101
100

# FIG. 7E

130
120
110
101
100

# FIG. 7F

130

120
110
101
100

180

# FIG. 7G

130

141
120
110
101
100

180

# FIG. 7H

# FIG. 7I

# FIG. 7J

# FIG. 7K

# FIG. 7L

130
160
150
143
142 } 140
141
120
110
101
100

180

# FIG. 7M

170

130
160
150
143
142 } 140
141
120
110
101
100

180    115

# FIG. 7N

# FIG. 8

| | Progressing S601 to S603 in FIG. 6 |
|---|---|
| S604 | After forming the three-dimensional structure (130), patterning the three-dimensional structure (130) |
| S605 | Patterning the auxiliary electrode (120) using the three-dimensional structure (130) |
| S606 | |

| S6061 | Ashing the three-dimensional structure (130) |
|---|---|
| S6062 | Patterning a third protective film (113) and a second protective film (112) |
| S6063 | Etching the second protective film (112) |

| S607 | After forming the anode electrode (141), patterning the anode electrode (141) |
|---|---|
| S608 | Depositing the organic light-emitting layer (142) |
| S609 | Depositing the cathode electrode (143) |
| | Progressing S610~612 in FIG. 6 |

# FIG. 9

# FIG. 10A

# FIG. 10B

# FIG. 10C

# FIG. 10D

# FIG. 10E

# FIG. 10F

# FIG. 10G

# FIG. 11

|  | First Embodiment | Third Embodiment | Fourth Embodiment | Fifth Embodiment | Sixth Embodiment | Seventh Embodiment | Eighth Embodiment |
|---|---|---|---|---|---|---|---|
| [Cross-sectional Structure]→<br>[Manufacturing Process]→ | [FIG. 4]<br>[FIG. 6] | [FIG. 12]<br>[FIG. 16] | [FIG. 13]<br>[FIG. 16] | [FIG. 14]<br>[FIG. 16] | [FIG. 17]<br>[FIG. 21] | [FIG. 18]<br>[FIG. 21] | [FIG. 19]<br>[FIG. 21] |
| Auxiliary Electrode(120) | Reflective film or metal<br>(ITO/Ag/Ti or ITO/Ti or Ti or Mo etc) | | | | | | |
| Three-dimensional Structure (130) | Color filter<br>(Resin) | | Transparent<br>(Organic or inorganic film) | | Black or transparent<br>(Organic or inorganic film) | | |
| Anode Electrode(141) | Transparent<br>(ITO or IZO) | | | | Reflective film<br>(ITO or IZO on Ag or Al) | | |
| Cathode Electrode (143) | Transparent or translucent<br>(Mg:Ag, ITO, IZO) | | | | | | |
| First Resin Layer(160) | Black<br>(Resin) | | Color filter<br>(Resin) | | Black<br>(Resin) | | - |
| Light Guide Layer(190) | - | - | - | Reflective<br>(Al or Ag or Ag Alloy) | | Organic film, inorganic film, double structure | |
| Second Resin Layer(170) | Color filter<br>(Resin) | Transparent<br>(Resin) | Black<br>(Resin) | Black<br>(Resin) | | Color filter<br>(Resin) | |

# FIG. 12

# FIG. 13

# FIG. 14

# FIG. 15

Pass-4  Pass-1  Pass-2 Pass-3 Pass-5

170
160
190

130

150
143
142 } 140
141
120
101
100

110

# FIG. 16

START

| S601 | Forming a driving circuit (101) on the substrate (100) |
|------|-------------------------------------------------------|
| S602 | Patterning a through hole (114) after forming a protective layer (110) |
| S603 | Forming an auxiliary electrode (120) |

| S604 | After forming a color three-dimensional structure (130),patterning the three-dimensional structure (130) | After forming a transparent three-dimensional structure (130), patterning the three-dimensional structure (130) |
|------|---|---|

| S605 | Patterning the auxiliary electrode (120) using the three-dimensional structure (130) |
|------|----------------------------------------------------------------------------------|
| S606 | Forming an anode separation structure (180) |
| S607 | After forming an anode electrode (141), patterning the anode electrode (141) |

Progressing S608~610 in FIG. 6

| S611 | First resin layer(160); Patterning Black Resin | First resin layer(160); Patterning CF Resin |
|------|---|---|

| S1610 | | | Patterning the light guide layer(190) |
|-------|--|--|---|

| S612 | Second resin layer(170); Patterning Transparent Resin | Second resin layer(170); Patterning Black Resin | Second resin layer(170); Transparent or Patterning Black Resin |
|------|---|---|---|

| Third Embodiment | Fourth Embodiment | Fifth Embodiment |
|---|---|---|

# FIG. 17

# FIG. 18

# FIG. 19

# FIG. 20

# FIG. 21

START

Progressing S601~606 in FIG. 6

| S607 | Patterning a reflective anode electrode(141) | Patterning a reflective anode electrode(141); Removing the anode electrode(141) on an upper surface of the three-dimensional structure |

Progressing S608~610 in FIG. 6

| S2110 | | Forming a light guide layer(190); Removing the light guide layer on the upper surface of the three-dimensional structure |

| S611 | First resin layer(160); Patterning CF Resin | First resin layer(160); Patterning Black Resin | First resin layer(160); Patterning CF Resin |

| S1610 | Forming the light guide layer(190) |

| S612 | Second resin layer(170); Patterning Black Resin | Second resin layer(170); Patterning CF Resin |

| Sixth Embodiment | Seventh Embodiment | Eighth Embodiment |

## INTERNATIONAL SEARCH REPORT

| International application No. |
|---|
| **PCT/KR2023/020613** |

| | |
|---|---|
| **A.** | **CLASSIFICATION OF SUBJECT MATTER** |

**H10K 59/38**(2023.01)i; **H10K 59/123**(2023.01)i; **H10K 59/80**(2023.01)i; **H10K 59/35**(2023.01)i; **H10K 50/15**(2023.01)i; **H10K 50/16**(2023.01)i; **H10K 50/17**(2023.01)i

According to International Patent Classification (IPC) or to both national classification and IPC

| | |
|---|---|
| **B.** | **FIELDS SEARCHED** |

Minimum documentation searched (classification system followed by classification symbols)

H10K 59/38(2023.01); H01L 21/02(2006.01); H01L 27/32(2006.01); H01L 51/52(2006.01); H05B 33/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 유기 발광 표시 장치(organic light emitting display device), 서브픽셀 (subpixel), 보조 전극(auxiliary electrode), 입체 구조물(three-dimensional structure), 유기 발광 소자(organic light emitting device), 아노드 전극(anode electrode), 아노드 분리 구조(anode separation structure), 광 안내층(light guiding layer)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| Y | US 11139352 B1 (WUHAN CHINA STAR OPTOELECTRONICS SEMICONDUCTOR DISPLAY TECHNOLOGY CO., LTD.) 05 October 2021 (2021-10-05) See column 4, line 10 - column 5, line 54 and column 7, lines 1-2; and figures 1-2, 4 and 6. | 1-6,9-13 |
| A | | 7-8,14-26 |
| Y | KR 10-2018-0002471 A (LG DISPLAY CO., LTD.) 08 January 2018 (2018-01-08) See paragraphs [0043], [0050]-[0053], [0059], [0061] and [0064]; and figure 5. | 1-6,9-13 |
| A | KR 10-2011-0132816 A (SAMSUNG MOBILE DISPLAY CO., LTD.) 09 December 2011 (2011-12-09) See paragraphs [0030]-[0049]; and figures 1-3. | 1-26 |
| A | KR 10-2015-0057739 A (SAMSUNG DISPLAY CO., LTD.) 28 May 2015 (2015-05-28) See paragraphs [0026]-[0050]; and figure 1. | 1-26 |

☑ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **19 March 2024** | **19 March 2024** |

| Name and mailing address of the ISA/KR | Authorized officer |
|---|---|
| **Korean Intellectual Property Office** **Government Complex-Daejeon Building 4, 189 Cheongsa-** **ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2023/020613**

**C.    DOCUMENTS CONSIDERED TO BE RELEVANT**

| Category* | Citation of document, with indication, where appropriate, of the relevant passages | Relevant to claim No. |
|---|---|---|
| A | KR 10-1202352 B1 (SAMSUNG DISPLAY CO., LTD.) 16 November 2012 (2012-11-16)<br>See paragraphs [0036]-[0056]; and figure 2. | 1-26 |

Form PCT/ISA/210 (second sheet) (July 2022)

### INTERNATIONAL SEARCH REPORT
#### Information on patent family members

International application No.

**PCT/KR2023/020613**

| Patent document cited in search report | | | Publication date (day/month/year) | Patent family member(s) | | | Publication date (day/month/year) |
|---|---|---|---|---|---|---|---|
| US | 11139352 | B1 | 05 October 2021 | CN | 109659338 | A | 19 April 2019 |
| | | | | WO | 2020-118841 | A1 | 18 June 2020 |
| KR | 10-2018-0002471 | A | 08 January 2018 | CN | 107579089 | A | 12 January 2018 |
| | | | | CN | 107579089 | B | 30 October 2020 |
| | | | | EP | 3264467 | A1 | 03 January 2018 |
| | | | | EP | 3264467 | B1 | 17 March 2021 |
| | | | | JP | 2018-006316 | A | 11 January 2018 |
| | | | | JP | 6605441 | B2 | 13 November 2019 |
| | | | | TW | 201801304 | A | 01 January 2018 |
| | | | | TW | I628789 | B | 01 July 2018 |
| | | | | US | 10069098 | B2 | 04 September 2018 |
| | | | | US | 2018-0006258 | A1 | 04 January 2018 |
| KR | 10-2011-0132816 | A | 09 December 2011 | US | 2011-0297943 | A1 | 08 December 2011 |
| KR | 10-2015-0057739 | A | 28 May 2015 | CN | 104659059 | A | 27 May 2015 |
| | | | | CN | 104659059 | B | 03 April 2020 |
| | | | | KR | 10-2151754 | B1 | 04 September 2020 |
| | | | | TW | 201526332 | A | 01 July 2015 |
| | | | | TW | I660534 | B | 21 May 2019 |
| | | | | US | 2015-0137090 | A1 | 21 May 2015 |
| | | | | US | 9318543 | B2 | 19 April 2016 |
| KR | 10-1202352 | B1 | 16 November 2012 | JP | 2012-028316 | A | 09 February 2012 |
| | | | | JP | 5941251 | B2 | 29 June 2016 |
| | | | | KR | 10-2012-0009606 | A | 02 February 2012 |
| | | | | US | 2012-0012848 | A1 | 19 January 2012 |
| | | | | US | 8410483 | B2 | 02 April 2013 |

Form PCT/ISA/210 (patent family annex) (July 2022)